(19) **Europäisches Patentamt**

**European Patent Office**

**Office européen des brevets**

(11) **EP 1 334 563 B1**

(12) **EUROPÄISCHE PATENTSCHRIFT**

(45) Veröffentlichungstag und Bekanntmachung des Hinweises auf die Patenterteilung:
**29.12.2004 Patentblatt 2004/53**

(51) Int Cl.⁷: **H03M 13/41**

(21) Anmeldenummer: **01989014.4**

(86) Internationale Anmeldenummer:
**PCT/DE2001/004040**

(22) Anmeldetag: **24.10.2001**

(87) Internationale Veröffentlichungsnummer:
**WO 2002/035820 (02.05.2002 Gazette 2002/18)**

(54) **VERFAHREN UND VORRICHTUNG ZUM DEKODIEREN EINER FOLGE PHYSIKALISCHER SIGNALE, ZUVERLÄSSIGKEITSWERT-ERMITTLUNGSEINHEIT UND VITERBI-DEKODIEREINHEIT**

METHOD AND DEVICE FOR DECODING A SEQUENCE OF PHYSICAL SIGNALS, RELIABILITY DETECTION UNIT AND VITERBI DECODING UNIT

PROCEDE ET DISPOSITIF POUR LE DECODAGE D'UNE SUITE DE SIGNAUX PHYSIQUES, UNITE DE DETERMINATION DE VALEURS DE FIABILITE ET DECODEUR DE VITERBI

(84) Benannte Vertragsstaaten:
**DE FR GB IT**

(30) Priorität: **24.10.2000 DE 10052709**

(43) Veröffentlichungstag der Anmeldung:
**13.08.2003 Patentblatt 2003/33**

(73) Patentinhaber: **Infineon Technologies AG**
**81669 München (DE)**

(72) Erfinder:
- **BECKER, Burkhard**
  **85737 Ismaning (DE)**
- **DOETSCH, Markus**
  **CH-3098 Schliern (CH)**
- **JUNG, Peter**
  **67697 Otterberg (DE)**
- **KELLA, Tideya**
  **80337 München (DE)**
- **PLECHINGER, Jörg**
  **80469 München (DE)**
- **RUSCITTO, Alfredo**
  **I-10131 Torino (IT)**
- **SCHMIDT, Peter**
  **67167 Erpolzheim (DE)**
- **SCHNEIDER, Michael**
  **81541 München (DE)**

(74) Vertreter: **Viering, Jentschura & Partner**
**Steinsdorfstrasse 6**
**80538 München (DE)**

(56) Entgegenhaltungen:
EP-A- 0 670 636    EP-A- 0 800 280
GB-A- 2 305 827    US-A- 5 822 340

- **TAEK WON KWON ET AL: "A modified two-step SOVA-based turbo decoder for low power and high performance" TENCON 99. PROCEEDINGS OF THE IEEE REGION 10 CONFERENCE CHEJU ISLAND, SOUTH KOREA 15-17 SEPT. 1999, PISCATAWAY, NJ, USA,IEEE, US, 15. September 1999 (1999-09-15), Seiten 297-300, XP010368291 ISBN: 0-7803-5739-6**
- **PATENT ABSTRACTS OF JAPAN vol. 1999, no. 12, 29. Oktober 1999 (1999-10-29) & JP 11 186914 A (MATSUSHITA ELECTRIC IND CO LTD), 9. Juli 1999 (1999-07-09) in der Anmeldung erwähnt**

**Beschreibung**

Die Erfindung betrifft ein Verfahren und eine Vorrichtung zum Dekodieren einer Folge physikalischer Signale.

Ein solches Verfahren und eine solche Vorrichtung sind aus [1] bekannt.

In [1] sind Grundlagen über den sogenannten Viterbi-Algorithmus beschrieben.

Bei dem Viterbi-Algorithmus, der oftmals im Rahmen der Kanaldekodierung gestörter, empfangener physikalischer Signale eingesetzt wird, wird für die empfangenen physikalischen Signale entlang einer sogenannten Trellis eine Folge von Signalwerten ermittelt. Für die Folge von Signalwerten wird jeweils die Wahrscheinlichkeit, dass die ermittelte Folge von Signalwerten der Folge von empfangenen physikalischen Signalen entspricht, maximiert. Bei der aus [1] bekannten Vorgehensweise wird für jeden Signalwert binär entschieden, ob es sich um einen Signalwert eines ersten binären Wertes oder eines zweiten binären Wertes handelt.

Nachteilig bei der aus [1] bekannten Vorgehensweise ist insbesondere, dass bei der Dekodierung nicht ersichtlich ist, wie zuverlässig die Entscheidung ist, ob der jeweils ermittelte Signalwert tatsächlich dem ursprünglich gesendeten Signalwert entspricht.

Somit ist bei dem Verfahren aus [1] keinerlei Zuverlässigkeitsinformation über die Qualität der Kanaldekodierung erhältlich.

Zur Verbesserung des aus [1] bekannten Verfahren, ist es aus [2] bekannt, jedem ermittelten Signalwert im Rahmen der Kanaldekodierung des empfangenen, verrauschten, das heißt gestörten physikalischen Signals eine Zuverlässigkeitsinformation, die im weiteren als Zuverlässigkeitswert bezeichnet wird, zuzuordnen. Mit dem Zuverlässigkeitswert wird jeweils angegeben, wie zuverlässig die jeweilige Entscheidung, das empfangene Signal als den entsprechenden Signalwert zu klassifizieren, getroffen wurde. Anschaulich bedeutet dies, dass mit dem Zuverlässigkeitswert angegeben wird, wie stark das empfangene Signal dem ersten binären Signalwert oder dem zweiten bi.nären Signalwert ähnelt.

Die Zuverlässigkeitswerte werden beispielsweise gebildet abhängig von sogenannten Zustands-Metriken, die beim Durchlaufen der Trellis im Rahmen der Kanaldekodierung berechnet werden.

Bei dem aus [2] bekannten Verfahren werden die Zuverlässigkeitswerte im Rahmen eines einmaligen Durchführens des Viterbi-Algorithmus ermittelt.

Es hat sich jedoch gezeigt, dass diese Vorgehensweise insbesondere auch im Hinblick auf eine Implementierung in Hardware nicht optimal ist.

Um die aus [2] bekannte Vorgehensweise zu verbessern, wurde das in [3] beschriebene Verfahren entwickelt, bei dem der Viterbi-Algorithmus zwei Mal durchgeführt wird, wobei im Rahmen des ersten "Durchlaufs" nur die Signalwerte ermittelt werden und im Rahmen eines zweiten Durchlaufs die Zuverlässigkeitswerte bestimmt werden. Ergebnis des ersten "Dirchlaufs" ist ein sogenannter Maximum-Likelihood-Pfad in dem die Signalwerte enthalten sind, die gemäß einem Pfadrückverfolgungsverfahren (Backtracing-Verfahren) ermittelt wurden. Die Signalwerte, die sich auf dem Maximum-Likelihood-Pfad befinden, werden als die dekodierten physikalischen Signale verwendet.

Bei der aus [3] bekannten Vorgehensweise wird beim zweiten Durchführen des Viterbi-Algorithmus für eine Vielzahl weiterer Pfade entlang der gesamten Trellis, wobei die weiteren Pfade alle die gleiche Länge wie der Maximum-Likelihood-Pfad aufweisen, nämlich die Länge entsprechend der Folge empfangener physikalischer Signale, Zuverlässigkeitswerte bestimmt und der jeweilige dem Signalwert zugeordnete Zuverlässigkeitswert wird abhängig von den Zuverlässigkeitswerten der Signalwerte des Maximum-Likelihood-Pfads und ermittelter Zuverlässigkeitswerte für Signalwerte der weiteren Pfade ermittelt.

Diese Vorgehensweise ist sehr aufwendig und praktisch nicht in Echtzeit zur Dekodierung physikalischer Signale, insbesondere im Bereich Mobilfunk, einsetzbar.

Weiterhin ist es aus [4] und [5] bekannt, den Viterbi-Algorithmus nicht für die gesamte Folge physikalischer Signale, sondern nur für eine Teilfolge durchzuführen und schrittweise entlang der Trellis die Signalwerte zu ermitteln, wobei im Rahmen des Viterbi-Algorithmus weitere Pfade gebildet werden und für diese weiteren Pfade den ermittelten Signalwerten weitere Zuverlässigkeitswerte zugeordnet werden, die mit den Zuverlässigkeitswerten der Signalwerte des zu diesem Zeitpunkt noch nicht vollständig ermittelten Maximum-Likelihood-Pfads verglichen werden, wodurch die endgültigen den ermittelten Signalwerten zugeordneten Zuverlässigkeitswerte ausgewählt werden.

Bei den aus [4] und [5] bekannten Verfahren besteht ein Nachteil insbesondere darin, dass für die jeweiligen Teilbereiche, die berücksichtigt werden zur Ermittelung der weiteren Pfade eine Konvergenz des Viterbi-Algorithmus nicht immer gewährleistet ist.

Ein anderes Verfahren zum Ermitteln eines Maximum Likelihood Pfades ist aus [6] bekannt. Bei diesem Verfahren wird ein erster Maximum Likelihood Pfad ermittelt und anschließend wird ein zusätzlicher Quasi-Maximum Likelihood Pfad ausgewählt und dessen Zuverlässigkeitswerte werden mit denen des ersten Maximum Likelihood Pfades verglichen.

Ein anderer Viterbi Decoder ist in [7] beschrieben.

Somit liegt der Erfindung das Problem zugrunde, Zuverlässigkeitswerte für Signalwerte im Rahmen eines Viterbi-Algorithmus zu ermitteln, wobei die ermittelten Zuverlässigkeitswerte eine gegenüber den bekannten Verfahren im stochastischen Sinn verbesserte oder mindestens gleichwertige Verlässlichkeit der ermittelten Zuverlässigkeitswerte aufweisen. Ferner soll das Verfahren im Mobilfunk einsetzbar sein, wobei ein möglichst geringer Berechnungsaufwand in Software oder auch in Hardware angestrebt wird.

Das Problem wird durch das Verfahren, die Vorrichtung, die Zuverlässigkeitswert-Ermittlungseinheit sowie die Viterbi-Dekodiereinheit mit den Merkmalen der unabhängigen Patentansprüche gelöst.

Bei einem Verfahren zum Dekodieren einer Folge physikalischer Signale wird für alle physikalischen Signale ein Viterbi-Algorithmus ein erstes Mal durchgeführt. Ergebnis des ersten "Durchlaufs" des Viterbi-Algorithmus ist ein Maximum-Likelihood-Pfad, der sich entlang der gesamten sich gemäß dem Viterbi-Algorithmus ergebenden Trellis ermittelt wurde. Der Maximum-Likelihood-Pfad weist für jedes physikalische Signal einen Signalwert auf. Für jeden gemäß dem Viterbi-Algorithmus ermittelten Signalwert des Maximum-Likelihood-Pfads wird ein Zuverlässigkeitswert ermittelt. Der Viterbi-Algorithmus wird nun ein zweites Mal durchgeführt, wobei folgende Verfahrensschritte iterativ durchgeführt werden solange, bis alle Signalwerte der ermittelten Trellis berücksichtigt worden sind:

- Es wird ein Teilbereich der Trellis ausgewählt, wobei der Teilbereich einen Teilanfangssignalwert und einen Teilendsignalwert auf dem Maximum-Likelihood-Pfad aufweist.
- Es wird mindestens ein weiterer Pfad in dem Teilbereich der Trellis ermittelt, der in dem Teilendsignalwert des Maximum-Likelihood-Pfads endet.
- Es wird jeder Signalwert auf dem weiteren Pfad ermittelt und mit dem entsprechenden Signalwert auf dem Maximum-Likelihood-Pfad zu demselben Zeitpunkt verglichen.
- Abhängig von dem Vergleichsergebnis wird dem Signalwert auf dem Maximum-Likelihood-Pfad der im vorherigen Iterationsschritt ermittelte Zuverlässigkeitswert oder das Minimum aus diesem und dem Zuverlässigkeitswert des Teilendsignalwertes zugeordnet.
- In einem folgenden Iterationsschritt wird der Teilbereich der Trellis vorzugsweise um mindestens eine Zeiteinheit verschoben.

Als dekodierte Folge werden die ermittelten Signalwerte und die den Signalwerten zugeordneten ausgewählten Zuverlässigkeitswerte, wie sie gemäß dem zweiten Durchführen des Viterbi-Algorithmus ermittelt worden sind, verwendet und gespeichert und/oder ausgegeben.

Eine Vorrichtung zum Dekodieren einer Folge physikalischer Signale weist einen Prozessor auf, der derart eingerichtet ist, dass die oben beschriebenen Verfahrensschritte des Verfahrens zum Dekodieren einer Folge physikalischer Signale durchführbar sind.

Eine Zuverlässigkeitswert-Ermittlungseinheit zum Ermitteln eines Zuverlässigkeitswerts im Rahmen eines Viterbi-Algorithmus weist einen ersten Pfadspeicher zum Speichern von Signalen eines Maximum-Likelihood-Pfads gemäß dem Viterbi-Algorithmus auf. Weiterhin ist ein zweiter Pfadspeicher zum Speichern von Signalwerten eines weiteren Pfades gemäß dem Viterbi-Algorithmus vorgesehen. Eine erste Auswahleinheit ist mit dem ersten Pfadspeicher und dem zweiten Pfadspeicher gekoppelt und dient zum Auswerten von Signalwerten aus dem ersten Pfadspeicher und dem zweiten Pfadspeicher. Eine Vergleichseinheit ist mit der Auswahleinheit gekoppelt und wird eingesetzt zum Miteinander-Vergleichen der ausgewählten Signalwerte aus dem ersten Pfadspeicher und dem zweiten Pfadspeicher. Eine zweite Auswahleinheit weist einen Steuereingang, einen ersten und einen zweiten Eingang auf. Der Steuereingang ist mit dem Ausgang der Vergleichseinheit gekoppelt. Der erste Eingang ist mit dem Ausgang einer dritten Auswahleinheit gekoppelt. Weiterhin ist ein Zuverlässigkeitswert-Speicher vorgesehen zum Speichern von Zuverlässigkeitswerten. Eine weiterhin vorgesehene Steuereinheit ist derart eingerichtet, dass aus dem Zuverlässigkeitswert-Speicher ein zuvor ermittelter und gespeicherter erster Zuverlässigkeitswert, der einem Signalwert auf dem Maximum-Likelihood-Pfad zugeordnet ist, auslesbar und einem ersten Eingang der dritten Auswahleinheit zuführbar ist. Weiterhin ist die Steuereinheit derart eingerichtet, dass aus dem Zuverlässigkeitswert-Speicher ein zuvor ermittelter und gespeicherter zweiter Zuverlässigkeitswert, der einem Signalwert auf dem Maximum-Likelihood-Pfad zugeordnet ist, einem zweiten Eingang der dritten Auswahleinheit zuführbar ist. Die Steuereinheit ist ferner derart eingerichtet, dass der erste Zuverlässigkeitswert dem zweiten Eingang der zweiten Auswahleinheit zuführbar ist. Bei Ungleichheit der ausgewählten Signalwerte aus dem ersten Pfadspeicher und dem zweiten Pfadspeicher ist von der Vergleichseinheit ein Steuersignal der zweiten Auswahleinheit zuführbar derart, dass von der zweiten Auswahleinheit der an ihrem ersten Eingang anliegende, von der dritten Auswahleinheit ausgewählte Zuverlässigkeitswert auswählbar ist.

Eine Viterbi-Dekodiereinheit weist die oben beschriebene Zuverlässigkeitswert-Ermittlungseinheit auf.

Durch die Erfindung wird ein verbessertes Dekodieren einer Folge physikalischer Signale unter Verwendung des Viterbi-Algorithmus erreicht. Insbesondere wird die Qualität. das heißt die stochastische Zuverlässigkeit der Zuverlässigkeitswerte, die den jeweiligen Signalwerten zugeordnet werden und als Soft-Decision-Werte von dem Viterbi-Dekodierer ausgegeben werden, erhöht, wodurch eine verbesserte Verlässlichkeit der einzelnen Signalwerte im Rahmen ihrer Weiterverarbeitung erreicht wird.

Es ist anzumerken, dass gemäß der Erfindung der Maximum-Likelihood-Pfad entlang der gesamten sich gemäß dem Viterbi-Algorithmus ergebenen Trellis ermittelt worden ist, bevor der Viterbi-Algorithmus ein zweites Mal durchgeführt wird, und dass im Rahmen der zweiten Durchführung die Signalwerte weiterer Pfade mit den Signalwerten des Maximum-Likelihood-Pfads verglichen werden.

Bevorzugte Weiterbildungen der Erfindung ergeben sich aus den abhängigen Ansprüchen.

Die im weiteren beschriebenen Ausgestaltungen der Erfindung betreffen sowohl das Verfahren, die Vorrichtung, die Zuverlässigkeitswert-Ermittlungseinheit als auch die Viterbi-Dekodiereinheit.

Als Signalwert kann ein binärer Wert verwendet werden. Durch diese Ausgestaltung wird die Implementierung der Erfindung vereinfacht, da lediglich binäre Werte verarbeitet werden müssen, wodurch beispielsweise im Rahmen der Speicherung der Signalwerte lediglich ein Bit für jeweils einen Signalwert benötigt wird.

Gemäß einer weiteren Ausgestaltung der Erfindung ist es vorgesehen, mindestens einen Anfangssignalwert zu Beginn der Folge physikalischer Signale und/oder mindestens einen Endsignalwert am Ende der Folge physikalischer Signale vorzugeben.

Als auszuwählender Teilbereich der Trellis kann ein Bereich ausgewählt werden, der eine vorgegebene Anzahl von Signalwerten aufweist.

Gemäß einer Ausgestaltung der Erfindung wird jeweils als Teilbereich der Trellis eine Anzahl von Signalwerten verwendet, die abhängig ist von der Rückgrifftiefe der verwendeten Faltungspolynome.

Der weitere Pfad kann jeweils in einer Iteration ermittelt werden, indem der Signalwert der zu dem jeweiligen Teilendsignalwert gemäß dem Maximum-Likelihood-Pfad geführt wird, invertiert wird und ausgehend von dem Teilendsignalwert, beginnend mit dem invertierten Signalwert ein erneutes Pfadrückverfolgungsverfahren durchgeführt wird. Im Rahmen des erneuten Pfadrückverfolgungsverfahrens wird Pfadrückverfolgungs-Information verwendet, die beim ersten Durchführen des Viterbi-Algorithmus ermittelt worden ist oder beim zweiten Durchführen wieder anfällt.

Jeder Signalwert auf dem Maximum-Likelihood-Pfad wird mit dem Signalwert auf dem weiteren konkurrierenden Pfad verglichen. Zeigt der Vergleich eine Übereinstimmung, so wird der Zuverlässigkeitswert des auf dem Maximum-Likelihood-Pfad liegenden Signalwertes nicht verändert. Zeigt der Vergleich keine Übereinstimmung, so wird für den betreffenden Signalwert auf dem Maximum-Likelihood-Pfad das Minimum aus dem in einer früheren Iteration bestimmten Zuverlässigkeitswert und dem Zuverlässigkeitswert des Teilendsignalwertes verwendet.

Als erste Näherung des Zuverlässigkeitswerts kann die Differenz aus akkumulierten Signalwertmetriken verwendet werden, die bei der Durchführung des Viterbi-Algorithmus gebildet werden.

In einer Weiterbildung der Erfindung ist die zweite Auswahleinheit ein Multiplexer.

Gemäß einer weiteren Ausgestaltung der Erfindung ist die erste Auswahleinheit derart eingerichtet, dass jeweils Signalwerte einer gleichen Zeiteinheit ausgewählt werden.

Die dritte Auswahleinheit kann derart eingerichtet sein, dass sie den kleineren Zuverlässigkeitswert aus dem ersten Zuverlässigkeitswert und dem zweiten Zuverlässigkeitswert auswählt.

Gemäß einer weiteren Ausgestaltung der Erfindung sind in der Vorrichtung folgende Komponenten vorgesehen:

o	eine Übergangs-Metrik-Ermittlungseinheit zum Ermitteln einer Übergangs-Metrik,
o	eine mit der Übergangs-Metrik-Ermittlungseinheit gekoppelten Endzustands-Metrik-Ermittlungseinheit zum Ermitteln einer Endzustands-Metrik,
o	eine mit der Endzustands-Metrik-Ermittlungseinheit gekoppelten Zuverlässigkeitswert-Ermittlungseinheit,
o	eine mit der Zuverlässigkeitswert-Ermittlungseinheit und der Endzustands-Metrik-Ermittlungseinheit gekoppelten Pfadrückverfolgungs-Einheit zum Ermitteln von Pfadrückverfolgungsinformation.

Weiterhin kann ein Speicher vorgesehen sein,

o	mit einem ersten Speicherbereich zum Speichern von Pfadrückverfolgungs-Informationen, und/oder
o	mit einem zweiten Speicherbereich zum Speichern von Soft-Eingangsinformationen für die Dekodiereinheit, und/oder
o	mit einem dritten Speicherbereich zum Speichern von ermittelten Zustandsmetriken und Zustandsübergangsmetriken, und/oder
o	mit einem vierten Speicherbereich zum Speichern von zur Ausgabe vorgesehenen Signalwerten und den Signalwerten zugeordneten Zuverlässigkeitswerten.

Zumindest einer der Speicherbereiche kann als RAM ausgestaltet sein, so dass die jeweiligen Speicherbereiche in der elektrischen Schaltung integriert sind, wodurch die Dekodierung weiter erheblich beschleunigt wird.

Ferner kann die Pfadrückverfolgungs-Einheit folgende Komponenten aufweisen:

o  eine Steuerungseinheit, und
o  einen Multiplexer, der über einen Steuereingang mit der Steuerungseinheit gekoppelt ist,

- wobei über den Steuereingang ausgewählt werden kann, ob durch den ersten Multiplexer Information über den Maximum-Likelihood-Pfad oder den jeweils weiteren konkurrierenden Pfad ausgewählt wird,
- wobei an einem ersten Eingang des ersten Multiplexers der jeweilige Start-Zustand für das Pfadrückverfolgungs-Verfahren innerhalb des weiteren konkurrierenden Pfades zuführbar ist,
- wobei an einem zweiten Eingang des ersten Multiplexers Information zuführbar ist darüber, ob ein Übergangsbit bei der Rückverfolgung des weiteren Pfades invertiert werden soll,
- wobei an einem dritten Eingang des ersten Multiplexers der jeweilige Zeitpunkt, auf den sich der Start-Zustand bezieht, zuführbar ist,
- wobei an einem vierten Eingang des ersten Multiplexers der jeweilige Start-Zustand des Maximum-Likelihood-Pfads zuführbar ist, und
- wobei an einem fünften Eingang des ersten Multiplexers der jeweilige Zeitpunkt, auf den sich der Start-Zustand des Maximum-Likelihood-Pfads bezieht, zuführbar ist.

Ein Ausführungsbeispiel der Erfindung ist in den Figuren dargestellt und wird im weiteren näher erläutert.
Es zeigen

Figur 1  ein Blockdiagramm, in dem die Zuverlässigkeitswert-Ermittlungseinheit gemäß einem Ausführungsbeispiel der Erfindung dargestellt ist.

Figur 2  ein Blockdiagramm, in dem das Senden, das Übertragen und das Empfangen eines elektrischen physikalischen Signals dargestellt ist.

Figur 3  eine Skizze einer Butterfly-Struktur, anhand der der Viterbi-Algorithmus näher erläutert wird.

Figur 4  ein Blockdiagramm, in dem ein PfadrückverfolgungsVerfahren dargestellt ist.

Figur 5  eine Skizze, in der die Vorgehensweise gemäß dem Ausführungsbeispiel der Erfindung dargestellt ist.

Figur 6  eine Skizze, in der die Vorgehensweise gemäß dem Ausführungsbeispiel der Erfindung im Detail dargestellt ist.

Figur 7  ein Blockdiagramm einer Viterbi-Dekodiereinheit gemäß einem Ausführungsbeispiel der Erfindung.

Figur 8  eine Skizze einer Pfadrückverfolgungseinheit der Viterbi-Dekodiereinheit gemäß einem Ausführungsbeispiel der Erfindung.

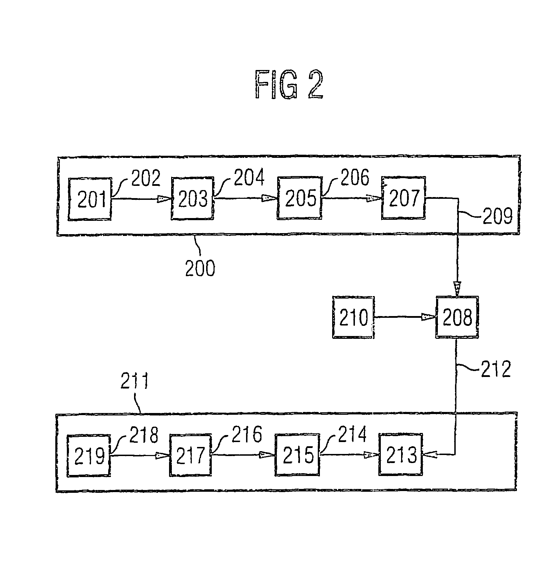

In Fig.2 ist symbolisch eine Quelle 201 dargestellt, von der aus eine Nachricht 202 von einem Sender 200 zu einer Senke 219 in einem Empfänger 211 übertragen werden soll.
Die zu übertragende Nachricht 202 wird einem Quellenkodierer 203 zugeführt, wo sie derart komprimiert wird, dass zwar keine Information verloren geht, aber für die Dekodierung der Nachricht 202 überflüssige Redundanzinformation eliminiert wird und somit die benötigte Übertragungskapazität verringert wird.
Ausgabe des Quellenkodierers 202 ist ein Codewort 204

$$\underline{u} \in \{\pm 1\}^k, \tag{1}$$

das aus einer Folge digitaler Werte besteht. Dabei ist für jedes Codewort 204 $\underline{u}$ vorausgesetzt, dass jeder Wert $u_i$, i = 1, ..., k, des Codeworts 204 $\underline{u}$ mit gleicher Wahrscheinlichkeit einen ersten binären Wert (logisch "0") bzw. einen zweiten binären Wert (logisch "1") annimmt.
Das Codewort 204 $\underline{u}$ wird einer Einheit zur Kanalkodierung 205 zugeführt, in der eine Kanalkodierung des Codewortes 204 $\underline{u}$ erfolgt. Bei der Kanalkodierung wird dem Codewort 204 $\underline{u}$ gezielt Redundanzinformation hinzugefügt, um bei der Übertragung möglicherweise entstehende Übertragungsfehler korrigieren oder zumindest erkennen zu können, womit eine hohe Übertragungszuverlässigkeit erreicht wird.
Im weiteren wird davon ausgegangen, dass durch die Kanalkodierung jedem Codewort 204

$$\underline{u} \in \{\pm 1\}^{k}$$

ein Kanalcodewort 206

$$\underline{c} \in \{\pm 1\}^{n}, \quad n > k, \quad n \in \mathbb{N} \tag{2}$$

zugeordnet wird.

Die Ausgabe der Einheit zur Kanalkodierung 205 besteht somit aus dem Kanalcodewort $\underline{c}$ 206.

Das Kanalcodewort $\underline{c}$ 206 wird einer Einheit zur Modulation 207 des Kanalcodewortes $\underline{c}$ 206 zugeführt.

Bei der Modulation wird dem Kanalcodewort $\underline{c}$ 206 eine für die Übertragung über einen physikalischen Kanal 208 geeignete Funktion

$$s : \mathfrak{R} \rightarrow \mathfrak{R}, \tag{3}$$

zugeordnet.

Das zu übertragende modulierte Signal 209 enthält also sowohl Signalinformation als auch aus der Signalinformation ermittelte Redundanzinformation.

Das modulierte Signal s 209 wird über den physikalischen Kanal 208 zu einem Empfänger 211 übertragen. Bei der Übertragung über den physikalischen Kanal 208 tritt häufig eine Störung 210 auf, die das modulierte Signal 209 s verfälscht.

Somit liegt bei dem Empfänger 211 ein verändertes moduliertes Signal 212

$$\tilde{s} : \mathfrak{R} \rightarrow \mathfrak{R}, \tag{4}$$

an, welches einer Einheit zur Demodulation 213 in dem Empfänger 211 zugeführt wird.

In der Einheit zur Demodulation 213 erfolgt eine Demodulation des veränderten modulierten Signals s 212. Ausgabe der Einheit zur Demodulation 213 ist ein im weiteren als elektrisches Signal 214 bezeichneter Vektor

$$\underline{y} \in \mathfrak{R}^{n}, \tag{5}$$

welcher das digitale, demodulierte veränderte Signal beschreibt.

Das elektrische Signal $\underline{y}$ 214 wird einer Einheit zum Kanaldekodieren 215 des elektrischen Signals $\underline{y}$ 214 zugeführt, wo es einem im weiteren beschriebenen Viterbi-Algorithmus zum Kanaldekodieren des elektrischen Signals $\underline{y}$ 214 unterzogen wird. Ein Folge elektrischer Signale $\underline{y}$ wird im weiteren auch als Folge physikalischer Signale bezeichnet.

Bei der Kanaldekodierung besteht die Aufgabe, eine sogenannte Soft-Decision-Dekodierung durchzuführen. Dies bedeutet, dass ein Codewort rekonstruiert wird und ferner für jede Komponente eine Zuverlässigkeitsinformation (Zuverlässigkeitswert) ermittelt wird, die die getroffene Entscheidung zur Rekonstruktion einer Komponente des Codeworts beschreibt. Eine Komponente des rekonstruierten Codeworts 216 wird im weiteren als digitaler Signalwert bezeichnet.

Das rekonstruierte Codewort 216, das heißt mindestens ein digitaler Signalwert, wird einer Einheit zur Quellendekodierung 217 zugeführt, in der eine Quellendekodierung erfolgt.

Das dekodierte Signal 218 wird schließlich der Senke 219 zugeführt.

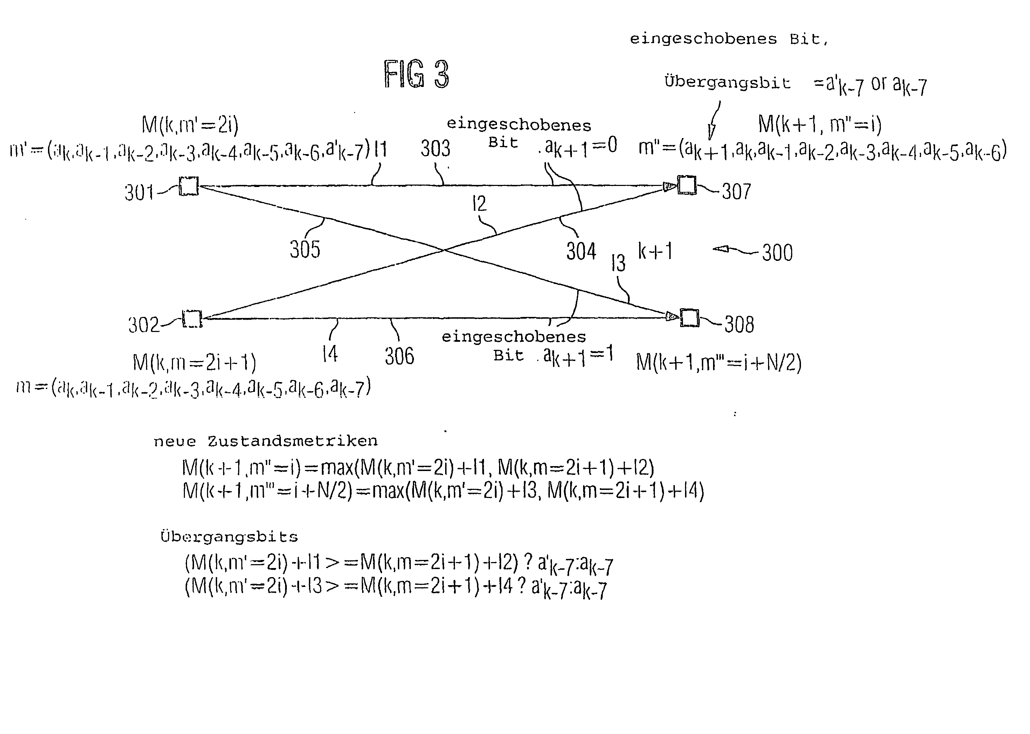

Im weiteren wird zum einfacheren Verständnis der Erfindung der Viterbi-Algorithmus in seiner Grobstruktur erläutert (vgl. Fig.3). Details über den Viterbi-Algorithmus sind in [1] beschrieben.

Im Rahmen dieses Ausführungsbeispiels wird von einem binär modulierten Signal ausgegangen, das heißt, es bietet sich für die Durchführung des Viterbi-Algorithmus eine Trellis an, die mittels einer Butterfly-Struktur 300, wie sie in **Fig.3** dargestellt ist, implementiert werden kann.

Es sind gemäß der Butterfly-Struktur 300 jeweils zwei Anfangszustände, ein erster Anfangszustand m' 301 und ein zweiter Anfangszustand m 302 vorgesehen. Der erste Anfangszustand m' 301 ergibt sich aus dem Produkt eines Zustandsindex i mit dem Faktor 2 (m' = 2i), wobei bei einem zu bearbeitenden 8-Bit-Wort i = 0, ..., 127 ($2^7$) und der zweite Zustand m 302 ergibt sich für den jeweiligen Zustandsindex i gemäß m = 2i + 1.

Zu einem Zeitpunkt k wird jedem Anfangszustand 301, 302 eine Zustandsmetrik M zugeordnet, für den ersten Anfangszustand m' 301 wird die Zustandsmetrik zum Zeitpunkt k also indiziert durch M(k, m' = 2i) und für den zweiten Anfangszustand m 302 wird die Zustandsmetrik zum Zeitpunkt k indiziert durch M(k, m = 2i + 1).

In der weiteren Beschreibung werden ohne Einschränkung der Allgemeingültigkeit die Ausführungen an den UMTS-Standard beispielhaft angelehnt. Die Ausführungen gelten ebenso für den GSM/EDGE-Standard, wobei ein Zustand in dem GSM/EDGE-Standard mit 6 Bit bzw. 4 Bit beschrieben wird.

Gemäß dem Ausführungsbeispiel, bei dem die physikalischen Signale gemäß dem UMTS-Standard übertragen werden, ist vorzugsweise ein Zustand mit einem 8-Bit-Wort beschrieben, das heißt, wenn mit $a_k$ ein Wert eines Bits zum Zeitpunkt k bezeichnet wird, ergibt sich für den ersten Anfangszustand 301 m' = ($a_k$, $a_{k-1}$, $a_{k-2}$, $a_{k-3}$, $a_{k-4}$, $a_{k-5}$, $a_{k-6}$, $a'_{k-7}$) und für den zweiten Anfangszustand m 302 ergibt sich m = ($a_k$, $a_{k-1}$, $a_{k-2}$, $a_{k-3}$, $a_{k-4}$, $a_{k-5}$, $a_{k-6}$, $a_{k-7}$).

Analog der Vorgehensweise bei einem Schieberegister erfolgt durch Eingabe ("Einschieben von links") eines neuen Bitwerts $a_{k+1}$ zu dem Zeitpunkt k + 1 ein Zustandsübergang, in Fig.3 symbolisiert durch Zustandsübergangspfeile 303, 304, 305, 306 in einen ersten Endzustand m'' 307 und einen zweiten Endzustand m''' 308.

Gemäß dem Zustandsübergang, verursacht durch das "Einschieben" des Bits $a_{k+1}$ ergibt sich für den ersten Endzustand 307 zum Zeitpunkt k + 1 (mit der Zustandsmetrik M(k + 1, m'' = i)):

$$m'' = (a_{k+1}, a_k, a_{k-1}, a_{k-2}, a_{k-3}, a_{k-4}, a_{k-5}, a_{k-6}).$$

Dem zweiten Endzustand 308 ist ebenfalls eine Zustandmetrik M (k + 1, m''' = i + $\frac{N}{2}$) zugeordnet.

Gemäß dem Viterbi-Algorithmus werden Übergangsmetriken I1, I2, I3, I4 ermittelt.

Mit I1 wird anschaulich die Wahrscheinlichkeit für einen Zustandsübergang in den Zustand m'' angegeben, wenn das Bit $a_{k+1}$ den logischen Wert "Null" aufweist und die Trellis sich in dem ersten Anfangszustand m' 301 befunden hat

Mit I2 wird anschaulich die Wahrscheinlichkeit für einen Zustandsübergang in den Zustand m'' angegeben, wenn das Bit $a_{k+1}$ den logischen Wert "Null" aufweist und die Trellis sich in dem zweiten Anfangszustand m 302 befunden hat.

Mit I3 wird anschaulich die Wahrscheinlichkeit für einen Zustandsübergang in den Zustand m''' bezeichnet, wenn das Bit $a_{k+1}$ den logischen Wert "Eins" aufweist und die Trellis sich in dem ersten Anfangszustand m' 301 befunden hat.

Mit I4 wird anschaulich die Wahrscheinlichkeit für einen Zustandsübergang in den Zustand m''' bezeichnet, wenn das Bit $a_{k+1}$ den logischen Wert "Eins" aufweist und die Trellis sich in dem zweiten Anfangszustand m 302 befunden hat.

Gemäß dem Viterbi-Algorithmus ergeben sich die neuen Zustandsmetriken der beiden Endzustände m'' und m''' gemäß folgenden Vorschriften:

$$M(k+1, m'' = i) = \max(M(k, m' = 2i) + I1, M(k, m = 2i+1) + I2),$$

$$M(k+1, m'' = i + \frac{N}{2}) = \max(M(k, m' = 2i) + I3, M(k, m = 2i+1) + I4),$$

wobei mit N die Anzahl der Zustände der Trellis bezeichnet wird, bei 8 Bit demnach N = 256 Zustände.

Gemäß dem Viterbi-Algorithmus wird in einem Vorwärts-Ermittlungsverfahren beginnend bei einem definierten Anfangszustand, der gemäß den UMTS-Standard eine vorgebbare Anzahl von Bits mit dem logischen Wert "Null" ist, sukzessiv derart ermittelt, dass für alle Anfangszustände der Trellis für einen Zeitpunkt die Zustandsmetriken ermittelt werden und gemäß der Butterfly-Struktur 300 die jeweiligen Zustandsübergangsmetriken ermittelt werden.

Sind jeweils die beiden Zustandsübergangsmetriken ermittelt worden, die beide ausgehend von unterschiedlichen Anfangszuständen in den gleichen Endzustand führen, so wird jeweils die Summe der jeweiligen Zustandsmetriken und Übergangsmetriken gebildet und es wird die größere Summe ausgewählt und als Zustandsmetrik dem entsprechenden Endzustand 307, 308 zugeordnet.

Das Bit $a'_{k-7}$, $a_{k-7}$ des jeweils durch die Maximum-Auswahl ausgewählten Anfangszustands wird in einem Pfadrückverfolgungs-Register (Traceback-Register) gespeichert.

Das oben beschriebene Verfahren wird für alle Zustände und für alle Zeitschritte der Trellis durchgeführt, bis der gemäß dem UMTS-Standard definierte Gesamt-Endzustand der Folge physikalischer Signale erreicht ist. Der Gesamt-Endzustand der Folge physikalischer Signale gemäß dem UMTS-Standard ist wiederum eine vorgegebene Anzahl von Bits mit dem logischen Wert "Null" (die Folge physikalischer Signale ist terminiert und wird auch als "tail bits" bezeichnet).

Anschaulich wird gemäß dem Vorwärtsverfahren somit jeweils die Information über den ausgewählten Pfad der beiden Zustandsübergänge, anders ausgedrückt die Information über den Ausgangszustand, der durch den Zustandsübergang in den jeweiligen Endzustand der Butterfly-Struktur 300 geführt hat, gespeichert. Der jeweilige Endzustand und der entsprechende Anfangszustand unterscheiden sich lediglich in 2 Bits auf folgende Weise:

Ein neues Bit wurde in das "Schieberegister" hineingeschoben (das Bit $a_{k+1}$) und ein Bit (das "älteste", das heißt, das niederwertigste, im weiteren als Übergangsbit bezeichnete Bit $a'_{k-7}$ bzw. $a_{k-7}$) wurde aus dem "Schieberegister" herausgeschoben.

Da das eingeschobene Bit $a_{k+1}$ Teil der unmittelbaren Bezeichnung des jeweiligen Endzustands ist, ist es ausreichend, lediglich das Übergangsbit $a'_{k-7}$ bzw. $a_{k-7}$ in dem Pfadrückverfolgungs-Register zu speichern, um es zu ermöglichen, den im weiteren beschriebenen Maximum-Likelihood-Pfad eindeutig ermitteln zu können.

Während des Pfadrückverfolgungs-Verfahrens werden die Übergangsbits $a'_{k-7}$ bzw. $a_{k-7}$ in Kombination mit dem Wissen über den Gesamt-Endzustand des Viterbi-Algorithmus, der gemäß dem UMTS-Standard in dem Gesamt-Endzustand mit dem logischen Wert "Null" endet, eingesetzt, um den Maximum-Likelihood-Pfad der Trellis zu rekonstruieren.

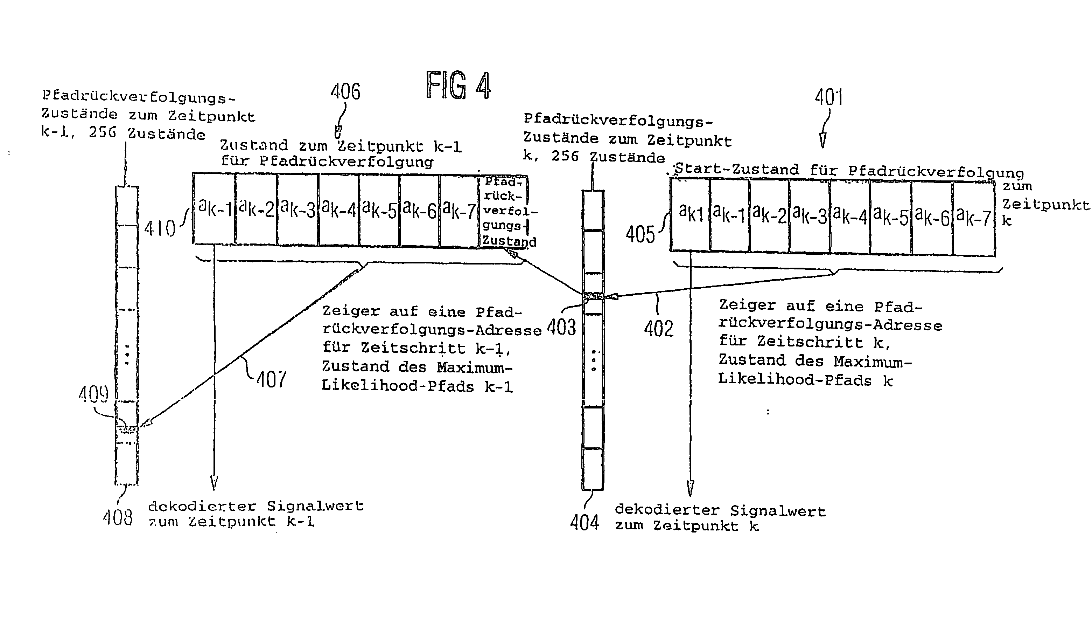

Wie in Fig.4 gezeigt ist, ist ein Start-Zustand 401 für das Pfadrückverfolgungs-Verfahren bekannt, wobei angenommen wird, dass das Pfadrückverfolgungsverfahren zu dem Zeitpunkt k begonnen wird. Der Start-Zustand 401 wird bezeichnet durch die Bits $a_k$, $a_{k-1}$, $a_{k-2}$, $a_{k-3}$, $a_{k-4}$, $a_{k-5}$, $a_{k-6}$, $a_{k-7}$ und bildet einen Zeiger 402 auf eine Adresse in einem Pfadrückverfolgungs-Register 404 für den Zeitschritt k, das bei einer Wortlänge von 8 Bit 256 Werte enthält. In dem Pfadrückverfolgungsregister 404 für den Zeitschritt k sind 256 Bit gespeichert, die jeweils durch die 8 Bit des Start-Zustands 401 eindeutig adressierbar sind.

Das adressierte Bit 403 in dem Pfadrückverfolgungs-Register 404 für den Zeitpunkt k wird ausgelesen und in das Schieberegister, das zum Zeitpunkt k die 8 Bits $a_k$, $a_{k-1}$, $a_{k-2}$, $a_{k-3}$, $a_{k-4}$, $a_{k-5}$, $a_{k-6}$, $a_{k-7}$, die den Start-Zustand 401 bilden, "von rechts" hineingeschoben. Das zum Zeitpunkt k höchstwertige Bit $a_k$ wird demgemäss aus dem Schieberegister herausgeschoben und wird als dekodierter Signalwert 405 zum Zeitpunkt k verwendet.

Das in dem Schieberegister sich befindende neue Wort, das einen Pfadrückverfolgungs-Zustand 406 zum Zeitpunkt k-1 bildet ($a_{k-1}$, $a_{k-2}$, $a_{k-3}$, $a_{k-4}$, $a_{k-5}$, $a_{k-6}$, $a_{k-7}$, ausgewähltes Bit 403 aus dem Pfadrückverfolgungs-Register 404 zum Zeitpunkt k) wird wiederum als Zeiger 407 auf ein Bit in einen Pfadrückverfolgungs-Register 408 für den Zeitpunkt k-1 verwendet. Das adressierte Bit 409 in dem Pfadrückverfolgungs-Register 408 für den Zeitpunkt k-1 wird ausgelesen, und es erfolgt ein weiterer Zustandsübergang in einen weiteren Pfadrückverfolgungs-Zustand zu dem Zeitpunkt k-2. Das zum Zeitpunkt k-1 höchstwertige Bit $a_{k-1}$ wird demgemäss aus dem Schieberegister herausgeschoben und wird als dekodierter Signalwert 410 zum Zeitpunkt k-1 verwendet.

Das oben skizzierte Verfahren wird für alle Zeitpunkte durchgeführt solange, bis der Anfangszustand der Trellis, das heißt der Zeitpunkt, zu dem das erste physikalische Signal empfangen worden ist, ermittelt wurde.

Es ist anzumerken, dass jedes Pfadrückverfolgungs-Register zu jedem Zeitpunkt bei einer Wortlänge von 8 Bit 256 Bits aufweist für jeweils 256 Zustände.

Ergebnis des Pfadrückverfolgungs-Verfahrens gemäß diesem ersten "Durchlauf" des Viterbi-Algorithmus ist der sogenannte Maximum-Likelihood-Pfad 501.

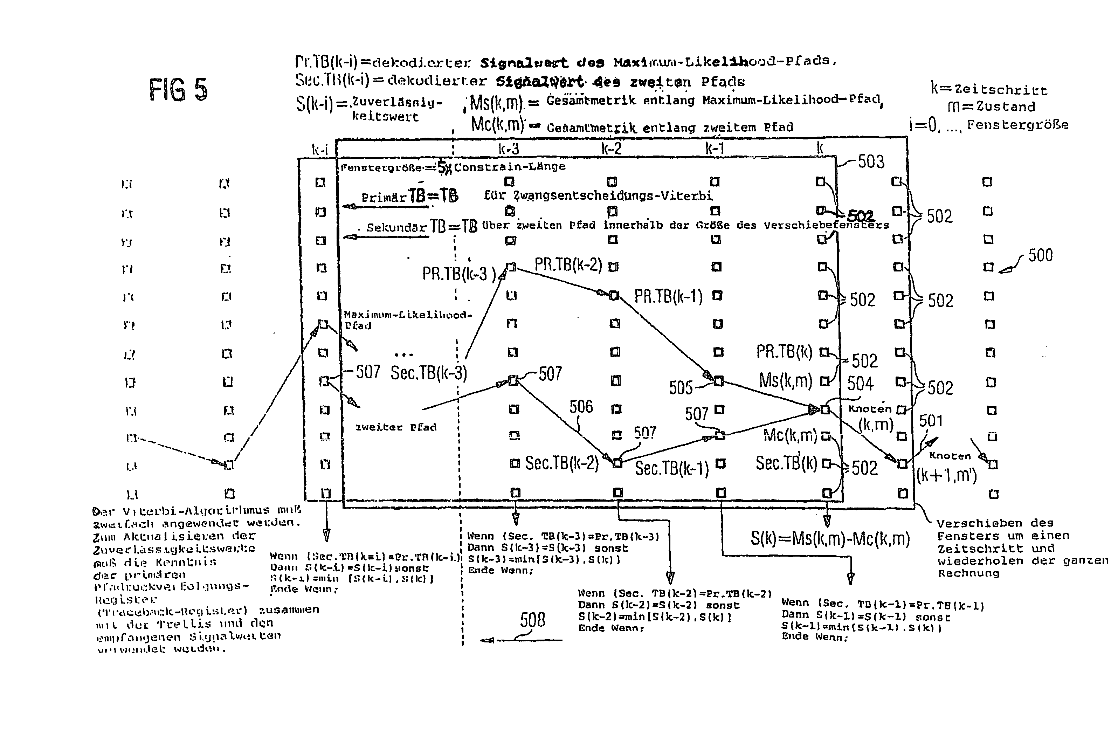

Nachdem der in **Fig.5** in der Trellis 500 gezeigte Maximum-Likelihood-Pfad 501 ermittelt worden ist, wird der Viterbi-Algorithmus gemäß der im weiteren beschriebenen Vorgehensweise ein zweites Mal durchgeführt.

In **Fig.5** sind für die Trellis 500 jeweils für einen Zeitschritt die jeweiligen Zustände mit dem Bezugszeichen 502 bezeichnet.

Der Maximum-Likelihood-Pfad 501 enthält die gemäß dem Pfadrückverfolgungs-Verfahren ermittelten Signalwerte, die als die dekodierten physikalischen Signale, das heißt als die dekodierte Folge der physikalischen Signale verwendet wird.

Wie in **Fig.5** dargestellt ist, wird aus der gesamten Trellis 500 ein Teilbereich 503 ausgewählt.

Ziel des im weiteren beschriebenen Verfahrens ist es, die den einzelnen Signalwerten zugeordneten Zuverlässigkeitswerte im Sinne einer "Worst-Case-Abschätzung" zu ermitteln.

Die Signalwerte des Maximum-Likelihood-Pfads 501 werden im weiteren mit Pr.TB(k-i) bezeichnet, wobei k-i die in dem ausgewählten Teilbereich 503 sich befindenden Zeitpunkte k, k-1, k-2, ..., k-i bezeichnet. Mit i ist ein Laufindex über die Zeitpunkte in dem Teilbereich 503 bezeichnet.

Der Teilbereich 503 kann anschaulich als Fenster betrachtet werden, das jeweils um einen Zeitschritt verschoben, beginnend am Anfang der Trellis 500 bis zum Ende der Trellis 500 durchgeschoben wird.

Gemäß dem Ausführungsbeispiel wird zu einem Teilendzustand 504 des Maximum-Likelihood-Pfads 501, der dem Signalwert zum Zeitpunkt k entspricht, ein zweiter Pfad gebildet.

Wie im vorangegangenen beschrieben wurde, ist ja der Bitwert, der in das Schieberegister von einem vorangegangenen Anfangszustand 505 eingeschoben worden ist, damit der Teilendzustand 504 auf dem Maximum-Likelihood-Pfad 501 erreicht wird, bekannt.

Zur Ermittlung eines zweiten Pfades 506 innerhalb der Trellis 500 für den ausgewählten Teilbereich 503 zu dem Zeitpunkt k wird das Übergangsbit, das den Übergang von dem Zustand 505 in den Teilendzustand 504 auf dem Maximum-Likelihood-Pfad 501 beschreibt, invertiert, und mit dem invertierten Bit wird unter der Verwendung des gespeicherten Pfadrückverfolgungs-Registers für den Zeitpunkt k (vgl. **Fig.4**) ein erneutes Pfadrückverfolgungs-Verfahren durchgeführt. Dies erfolgt auf die gleiche, oben im Zusammenhang mit **Fig.4** beschriebene Weise bis zu dem Anfangszustand der Trellis.

Ergebnis ist der zweite Pfad 506, der Zustände 507 enthält.

Nachdem der zweite Pfad bis zu dem Teilendzustand 504 ermittelt worden ist, wird ein erster Zuverlässigkeitswert für den Teilendzustand 504 in dem ausgewählten Teilbereich 503 für den Zeitschritt k ermittelt.

Der erste Zuverlässigkeitswert ergibt sich aus der Differenz der Zustandsmetrik des Teilendzustands 504 für den Fall, dass die Metrik über die Zustände des Maximum-Likelihood-Pfads 501 ermittelt worden sind und der Zustandsmetrik des Teilendzustands 504 für den Fall, dass die Zustandsmetrik über die Zustände 507 entlang des zweiten Pfades 506 ermittelt worden sind.

Diese Differenz stellt anschaulich einen Grad der Entscheidungssicherheit für den Übergang entlang des Maximum-Likelihood-Pfads 501 dar.

Ist beispielsweise die Differenz sehr gering, so bedeutet dies, dass, ohne einen statistisch großen Fehler zu begehen, ohne weiteres auch der Zustand über den zweiten Pfad 506 hätte erreicht werden können.

Ist die Differenz jedoch sehr groß, so ist es ein Anzeichen dafür, dass die Entscheidung für das entsprechende Bit, das heißt den Zustand des Maximum-Likelihood-Pfads 501 sehr sicher ist.

Zum Zeitpunkt k sind somit für alle Zustände auf dem Maximum-Likelihood-Pfad 501 erste Zuverlässigkeitswerte ermittelt, die noch korrigiert werden müssen.

Entlang der in **Fig.5** mit dem Pfeil 508 symbolisierten Richtung wird jeweils für einen Zeitpunkt k - n, n = 1, ..., Größe ausgewählter Teilbereich, für den Zustand auf dem Maximum-Likelihood-Pfad 501 und dem Zustand auf dem zweiten Pfad 506 folgendes Verfahren durchgeführt:

o Es wird geprüft, ob der Signalwert, das heißt das Bit, das gemäß dem Maximum-Likelihood-Pfad 501 dekodiert worden ist, gleich ist dem Bit, welches gemäß dem zweiten Pfad 506 dekodiert worden wäre.

o Ist dies der Fall, so bleibt der erste Zuverlässigkeitswert für den Signalwert des jeweiligen Zustandes auf dem Maximum-Likelihood-Pfad 501 unverändert.

o Weisen die dekodierten Bits zu einem Zeitpunkt k - n auf dem Maximum-Likelihood-Pfad 501 und dem zweiten Pfad 506 unterschiedliche Werte auf, so wird das Minimum aus dem ersten Zuverlässigkeitswert, der dem jeweiligen Zustand auf dem Maximum-Likelihood-Pfad 501 zum Zeitpunkt k zugeordnet ist und dem des entsprechenden Zustands auf dem Maximum-Likelihood-Pfad 501 zu dem jeweiligen Zeitpunkt k - n, ermittelt und als neuer erster zuverlässigkeitswert dem Signalwert auf dem Maximum-Likelihood-Pfad 501 zum Zeitpunkt k - n zugeordnet.

o Dieses Verfahren wird entlang des Maximum-Likelihood-Pfads 501 und des zweiten Pfades 506 für alle Zustände auf dem Maximum-Likelihood-Pfad 501 innerhalb des ausgewählten Teilbereichs 503 durchgeführt.

Diese Vorgehensweise wird für den Teilbereich 503 in jeder Iteration, wobei der Teilbereich 503 jeweils um einen Zeitschritt entlang der Trellis 500 in Richtung des Gesamt-Endzustands der Folge physikalischer Signale verschoben wird, durchgeführt.

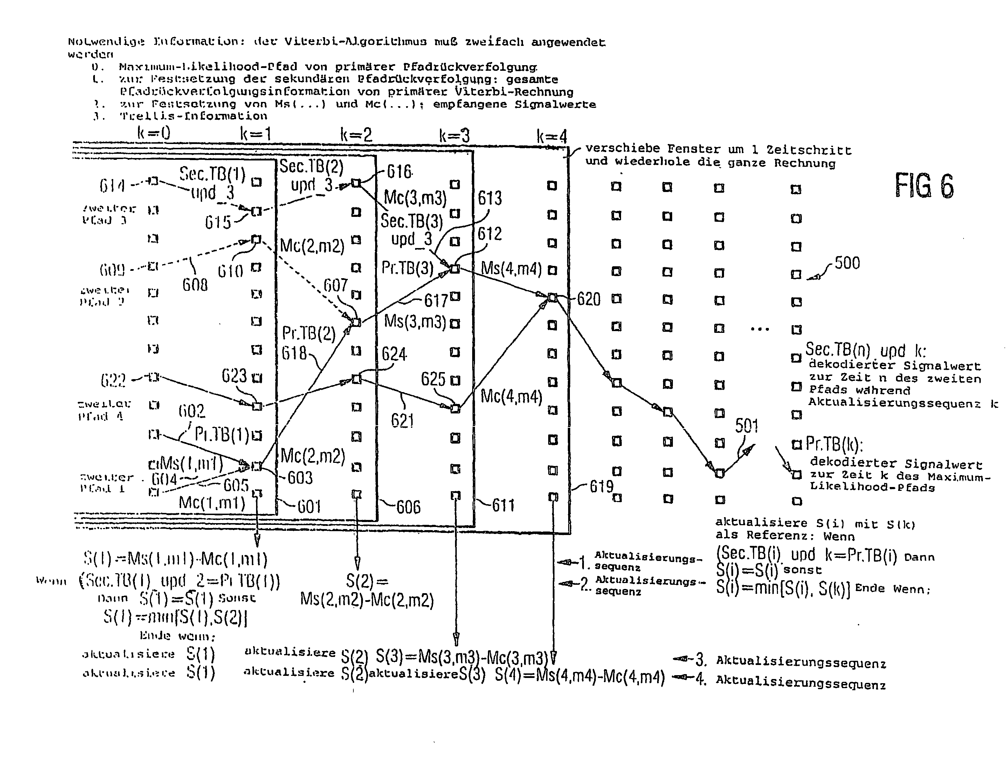

Die iterative Vorgehensweise wird im Zusammenhang mit Fig.6 detailliert weiter erläutert.

**Fig.6** zeigt die Trellis 500, sowie den Maximum-Likelihood-Pfad 501.

In **Fig.6** wird davon ausgegangen, dass das Verfahren bei einem ersten Zeitschritt k = 0 beginnt.

In einem ersten Schritt wird ein erster Teilbereich 601 ausgewählt, der die Zustände von zwei Zeitpunkten (k = 0, k = 1) enthält.

Wie **Fig.6** zeigt, enthält somit der erste Teilbereich 601 einen ersten Zweig 602 des Maximum-Likelihood-Pfads 501.

Gemäß dem oben beschriebenen Verfahren wird durch Invertieren des Übergangsbits, beginnend bei dem Teilendzustand 603 des ersten Teilbereichs 601 ein zweiter Pfad 604, der lediglich einen Zweig 605 aufweist, ermittelt.

Für den ersten Teilendzustand 603 wird nun der Zuverlässigkeitswert S(1) ermittelt durch Differenzbildung der Metriken Ms(k=1,m1) für den Maximum-Likelihood-Pfad 602 und Mc(k=1,m1) für den zweiten Pfad 604. Mit Ms(1,m1) wird demnach die Gesamtmetrik der akkumulierten Zustandsmetriken und Übergangsmetriken entlang des Maximum-Likelihood-Pfads 501 bis zu dem ersten Teilendzustand 603 bezeichnet, allgemein bis zu einem Zustand m zum Zeitpunkt k Ms (k, m). Mit Mc(k,m) wird entsprechend die Gesamtmetrik der akkumulierten Zustandsmetriken und Übergangsmetriken entlang des zweiten Pfades 604 bis zu dem ersten Teilendzustand 603, allgemein bis zu einem Zustand m zum Zeitpunkt k.

Nach Bilden des ersten Zuverlässigkeitswerts für den Zeitpunkt k = 1 (S(1)) ist die erste Iteration beendet.

In einer zweiten Iteration wird ein zweiter Teilbereich 606 ausgewählt, der nunmehr die Zustände der Trellis 500 für die Zeitpunkte k = 0, k = 1, k = 2 enthält.

In der zweiten Iteration weist der ausgewählte zweite Teilbereich 606 einen zweiten Teilendzustand 607 auf dem Maximum-Likelihood-Pfad 501 auf.

Ausgehend von dem zweiten Teilendzustand 607 wird nun wiederum ein neuer Pfad, der im weiteren als dritter Pfad 608 bezeichnet wird, mittels des üblichen Pfadrückverfolgungs-Verfahrens unter Verwendung der Pfadrückverfolgungs-Register ermittelt. Ferner werden sowohl die Zustandsübergangsmetriken für den zweiten Zweig 618 des Maximum-Likelihood-Pfads 501, der den Zustandsübergang von dem ersten Teilendzustand 603 zu dem zweiten Teilendzustand 607 bewertet, ermittelt.

Ferner wird die Zustandsmetrik für den Zustand 610 und die Zustandsübergangsmetrik für den zweiten Teilendzustand 607, der sich auf dem dritten Pfad 608 befindet, entlang des dritten Pfades 608 ermittelt.

Wiederum wird der erste Zuverlässigkeitswert S(2) für den Zeitpunkt k = 2 für den zweiten Teilendzustand 607 ermittelt gemäß folgender Vorschrift:

$$S(2) = Ms(2,m2) - Mc(2,m2).$$

In einem weiteren Schritt wird geprüft, ob das dekodierte Bit für den Zeitpunkt k = 1 entlang des dritten Pfades 608 ausgehend von dem zweiten Teilendzustand 607 gleich ist dem dekodierten Bit für den Maximum-Likelihood-Pfad 501 zu dem Zeitpunkt k = 1.

Bei Ungleichheit wird das Minimum gebildet zwischen dem Zuverlässigkeitswert S(1), der dem ersten Teilendzustand 603 zugeordnet ist und dem ersten Zuverlässigkeitswert S(2), der dem zweiten Teilendzustand 607 zugeordnet ist.

Der minimale Wert wird in einem weiteren Schritt dem ersten Teilendzustand 603 zugeordnet.

Damit ist die zweite Iteration beendet.

In einer dritten Iteration wird das Fenster (der Teilbereich) anschaulich um einen weiteren Zeitschritt nach rechts verschoben, das heißt der ausgewählte dritte Teilbereich 611 enthält nunmehr Zustände aus vier Zeitpunkten, nämlich k = 0, k = 1, k = 2, k = 3.

Das oben beschriebene Verfahren wird ausgehend von einem dritten Teilendzustand 612 derart ausgeführt, dass ein vierter Pfad 613 mittels eines weiteren Pfadrückverfolgungs-Verfahrens unter Verwendung der entsprechenden Pfadrückverfolgungs-Register ermittelt wird.

Aus der Zustandsmetrik des Zustands 616 und der Zustandsübergangsmetrik in dem dritten Teilendzustand 612 ist die Gesamtmetrik entlang des vierten Pfades 613, der im weiteren auch als konkurrierender Pfad bezeichnet wird, bekannt.

Weiterhin wird für den Zustandsübergang von dem zweiten Teilendzustand 607 in den dritten Teilendzustand 612, symbolisiert durch den dritten Zweig 617 auf Maximum-Likelihood-Pfad 501, die Zustandübergangsmetrik ermittelt.

Mit der Zustandsmetrik des zweiten Teilendzustands 607 ist demnach auch die totale Metrik entlang des Maximum-Likelihood-Pfads 501 bekannt.

Für den dritten Teilendzustand 612 wird der erste Zuverlässigkeitswert gebildet nach folgender Vorschrift:

$$S(3) = Ms(3,m3) - Mc(3,m3).$$

Ist der erste Zuverlässigkeitswert S(3) für den dritten Teilendzustand 612 ermittelt worden, so wird gemäß der oben beschriebenen Vorgehensweise für alle in dem dritten Teilbereich 611 sich befindenden Zustände auf dem Maximum-Likelihood-Pfad 501 der jeweilige erste Zuverlässigkeitswert aktualisiert oder nicht.

Damit ist die dritte Iteration beendet.

In der vierten Iteration wird wiederum der Teilbereich um einen Zeitschritt in der Richtung des Endes der Trellis 500 verschoben, so dass ein vierter Teilbereich 619 ausgewählt wird, der nunmehr Zustände aus fünf Zeitpunkten k = 0, k = 1, k = 2, k = 3, k = 4 enthält.

Zu einem vierten Teilendzustand 620 auf dem Maximum-' Likelihood-Pfad 501 wird gemäß der obigen Vorgehensweise ein fünfter Pfad 621 ermittelt.

Anschließend wird der erste Zuverlässigkeitswert S(4) für den vierten Teilendzustand 620 gemäß folgender Vorschrift ermittelt:

$$S(4) = Ms(4,m4) - Mc(4,m4).$$

Ausgehend von dem vierten Teilendzustand 620 wird sukzessiv für zeitlich vorangegangenen Zustände jeweils der erste Zuverlässigkeitswert aktualisiert oder nicht gemäß der oben dargelegten Vorgehensweise.

Ausgedrückt in einer Wenn-Dann-Abfrage einer Programmiersprache wird ein erster Zuverlässigkeitswert für einen jeweiligen Teilendzustand zu einem Zeitpunkt k gemäß folgender Bedingung aktualisiert oder nicht aktualisiert:

**Wenn** (Sec.TB(n_upd_k) = Pr.TB(n))

**Dann**

$$S(n) = S(n)$$

**Sonst**

$$S(n) = \min (S(n), S(k))$$

**Ende** Wenn-Dann-Schleife.

Mit Sec.TB(n_upd_k) wird das dekodierte Bit zum Zeitpunkt n auf dem jeweils konkurrierenden Pfad (zweiter Pfad, dritter Pfad, vierter Pfad, ...) während der Aktualisierungsiteration k ausgehend von einem Teilendzustand auf dem Maximum-Likelihood-Pfad 501 zum Zeitpunkt k bezeichnet.

Die Vorgehensweise ist anschaulich durch folgende heuristische Erkenntnis zu erläutern:

Der jeweilige erste Zuverlässigkeitswert zu Beginn der Iteration ist die obere Grenze des auszugebenen Zuverlässigkeitswerts. Je geringer der geschätzte Zuverlässigkeitswert des jeweiligen Teilendzustands ist, umso wahrscheinlicher ist es, dass der Teilendzustand auch über den jeweils weiteren Pfad erreicht werden kann. Deshalb ist der Zwischen-Zuverlässigkeitswert für einen Zustand auf dem Maximum-Likelihood-Pfad 501 zu aktualisieren innerhalb des ausgewählten Teilbereichs, wenn das entsprechende dekodierte Bit zu dem entsprechenden Zeitpunkt sich zwischen den Maximum-Likelihood-Pfad 501 und dem weiteren Pfad unterscheidet.

Wenn die Zuverlässigkeitswerte aller Zustände entlang des Maximum-Likelihood-Pfads 501 aktualisiert worden sind, wird das Zeitfenster, das heißt der Teilbereich einen Zeitschritt weiter in Richtung des Endes der Trellis verschoben.

Es wird der neue Zuverlässigkeitswert für den entsprechenden Teilendzustand zum Zeitpunkt k + 1 geschätzt, der entsprechende neue weitere Pfad wird bestimmt, und es werden die entsprechenden Zustandsmetriken und Zustandsübergangsmetriken ermittelt und wiederum werden die Zuverlässigkeitswerte der Zustände auf dem Maximum-Likelihood-Pfad 501 innerhalb des Teilbereichs der k + 1-ten Iteration aktualisiert.

Es ist anzumerken, dass der zuletzt aktualisierte Wert des zeitlich vorangegangenen Teilbereichs endgültig bestimmt ist und in den weiteren Iterationen nicht mehr berücksichtigt wird.

Die Zuverlässigkeitswerte aller Zustände im Zeitfenster auf dem Maximum-Likelihood-Pfad 501 werden in jeder Iteration abhängig der oben dargestellten Vorschrift aktualisiert solange, bis der entsprechende Zustand aus dem Zeitfenster bei einer weiteren Verschiebung herausfällt.

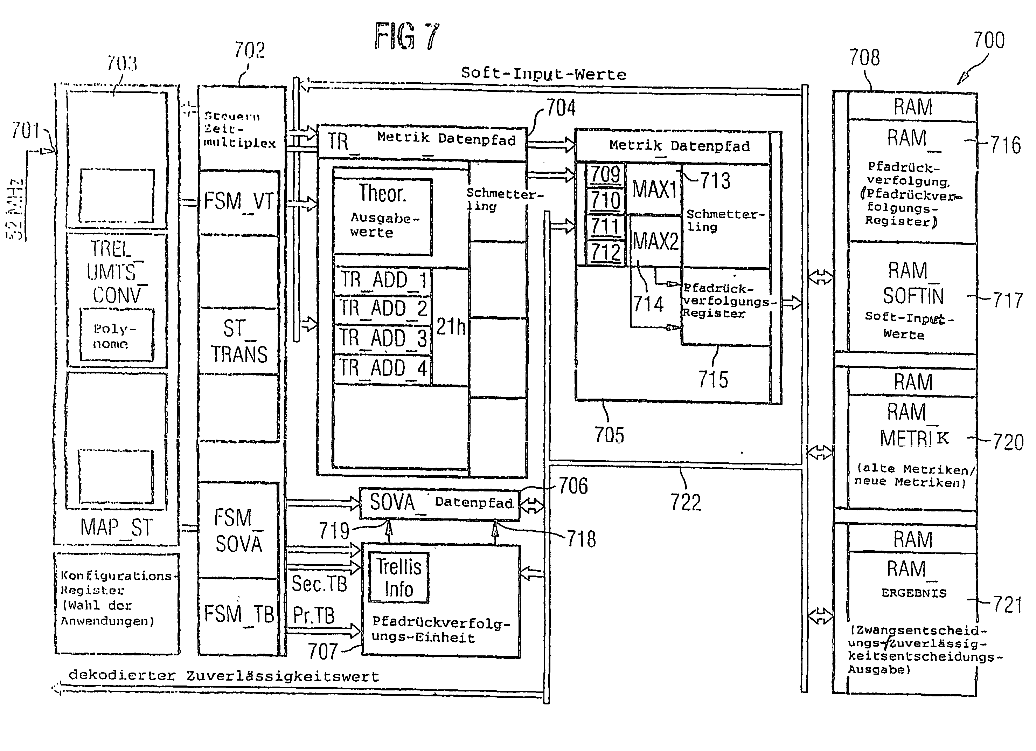

Fig.7 zeigt ein Blockdiagramm der Viterbi-Soft-Decision-Dekodiereinheit 700 gemäß dem Ausführungsbeispiel der Erfindung.

Die Viterbi-Dekodiereinheit 700 wird von einer externen Steuerung (nicht dargestellt), beispielsweise einem Signalprozessor, mit einer Frequenz von 52 MHz über einen Takteingang 701 getaktet.

Die Viterbi-Dekodiereinheit 700 weist eine interne Steuerungseinheit 702, eine Einheit 703 zum Abspeichern der Information über das Dekodierverfahren (Faltungspolynome), eine Übergangs-Metrik-Ermittlungseinheit 704, eine Endzustands-Metrik-Ermittlungseinheit 705, eine Zuverlässigkeitswert-Ermittlungseinheit 706 sowie eine Pfadrückverfolgungs-Einheit 707 auf.

Weiterhin ist ein Speicher 708 vorgesehen, der in verschiedene Teilbereiche aufgeteilt ist, zum Speichern der Softinput-Werte, der Traceback-Information sowie der dekodierten Bits und ihrer Zuverlässigkeitsinformation.

Daneben ist ein Speicher zum Abspeichern der temporären Information wie Start-Metriken vorgesehen.

Die Übergangs-Metrik-Ermittlungseinheit 707 bildet aufgrund der in der Einheit 703 zum Abspeichern der Information über das Dekodierverfahren gespeicherten Dekodierinformation für jeden Übergang in der Trellis die theoretische kodierte Ausgangsinformation und kombiniert diese mit den empfangenen Soft-Input-Werten aus dem Speicher zu den Übergangsmetrik-Werten gemäß der folgenden Vorschrift:

$$(2x_1-1)S1 + (2x_2-1)S2 + (2x_3-1)S3$$

wobei mit

- o   S1, S2, S3 die Soft-Input-Werte für den Dekoder, und
- o   $x_1$, $x_2$, $x_3$ die theoretisch kodierte Ausgangsinformation, bezeichnet werden.

Die Endzustands-Metrik-Ermittlungseinheit 705 ist mit der Übergangs-Metrik-Ermittlungseinheit 704 derart gekoppelt, dass ihr die ermittelten Zustandsübergangsmetriken zuführbar sind. In der Endzustands-Metrik-Ermittlungseinheit 705 sind vier Addierer 709, 710, 711, 712, zwei Einheiten 713, 714 zur Bildung eines Maximumwerts aus zwei vorher gebildeten Summen sowie ein Pfadrückverfolgungs-Register 715 vorgesehen, die gemäß der in Fig.3 dargestellten Butterfly-Struktur 300 realisiert sind.

In dem Pfadrückverfolgungs-Register 715 sind die jeweiligen Bits, die sich aufgrund der Auswahl der maximalen Summe aus Zustandsmetrik für den jeweiligen Anfangszustand der Butterfly-Struktur 300 und der Zustandsübergangsmetrik ergeben und nach dem oben beschriebenen Verfahren somit aus dem Schieberegister herausgeschoben werden, gespeichert.

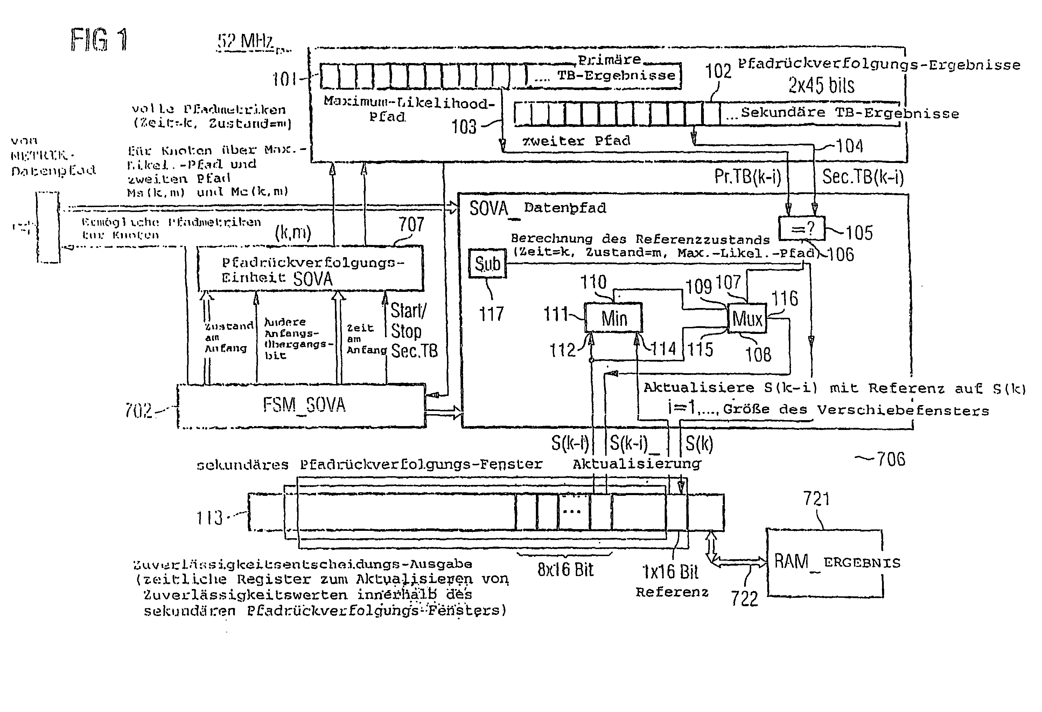

Von der mit der Steuerungseinheit 702 gekoppelten Zuverlässigkeitswert-Ermittlungseinheit 706, die in **Fig. 1** im Detail dargestellt ist, werden gemäß dem oben dargelegten Verfahren die Zuverlässigkeitswerte ermittelt und einem zweiten Speicherbereich 717 zum Speichern der Zuverlässigkeitswerte und der Zwischen-Zuverlässigkeitswerte, die noch während der Iterationen verändert werden können, gespeichert.

Weiterhin ist die Zuverlässigkeitswert-Ermittlungseinheit 706 mit der Pfadrückverfolgungseinheit 707 gekoppelt derart, dass von der Pfadrückverfolgungseinheit 707 der Zuverlässigkeitswert-Ermittlungseinheit 706, wie im weiteren erläutert wird, jeweils über einen ersten Eingang 718 das entsprechende Bit, das heißt das Übergangsbit für den jeweiligen Zeitschritt für die Zustände entlang des jeweiligen weiteren Pfades zu dem Zeitschritt k zugeführt wird und über eine zweite Kopplung 719 das Übergangsbit der jeweiligen Zustände auf dem Maximum-Likelihood-Pfad.

Die jeweils ermittelten Zustandsmetriken und Zustandsübergangsmetriken werden in einem dritten Speicherbereich 720 gespeichert.

In einem vierten Speicherbereich 721 werden zur Ausgabe vorgesehene Signalwerte und die endgültigen, den Signalwerten zugeordneten Zuverlässigkeitswerte gespeichert.

Die einzelnen Komponenten sind über einen Bus 722 miteinander gekoppelt.

**Fig.1** zeigt eine Skizze der Zuverlässigkeitswert-Ermittlungseinheit 706 im Detail. Bei einer maximalen Größe des Teilbereichs von 45 Zeiteinheiten, weist die Zuverlässigkeitswert-Ermittlungseinheit 706 gemäß dem Ausführungsbeispiel ein erstes Register 101 zur Speicherung der gemäß dem ausgewählten Teilbereich dekodierten Bits für die Zustandsübergänge entlang des Maximum-Likelihood-Pfads auf.

In einem zweiten Register 102, ebenfalls der Länge 45 Bit sind die dekodierten Bits gemäß dem Pfadrückverfolgungs-Verfahren entlang des jeweils ermittelten konkurrierenden Pfades innerhalb des ausgewählten Teilbereichs, gespeichert.

Über eine Auswahleinheit (nicht dargestellt) wird jeweils ein Bit aus dem ersten Register 101 und dem zweiten Register 102, das jeweils ein dekodiertes Bit zu einem gleichen Zeitpunkt beschreibt, einmal entlang des Maximum-Likelihood-Pfads 501 bzw. entlang des weiteren konkurrierenden Pfades ausgelesen. Diese Bits werden über zwei Kopplungen, eine erste Kopplung 103 und eine zweite Kopplung 104 einem Exklusiv-ODER-Gatter als Vergleichseinheit 105 zugeführt.

Ein Ausgang 106 der Vergleichseinheit 105 ist mit einem Steuereingang 107 eines Multiplexers 108 verbunden. Ein erster Eingang 109 des Multiplexers 108 ist mit einem Ausgang 110 einer Minimum-Auswahleinheit 111 gekoppelt. Ein erster Eingang 112 der Minimum-Auswahleinheit 111 ist mit einem Zuverlässigkeitswert-Speicher 113 gekoppelt. Ein zweiter Eingang 114 der Minimum-Auswahleinheit 111 ist ebenfalls mit dem Zuverlässigkeitswert-Speicher 113 gekoppelt. Ferner ist ein zweiter Eingang 115 des Multiplexers 108 ebenfalls mit dem ersten Eingang 112 der Minimum-Auswahleinheit 111 gekoppelt, so dass der an dem ersten Eingang 112 der Minimum-Auswahleinheit 111 anliegende Zuverlässigkeitswert auch an dem zweiten Eingang 115 des Multiplexers 108 anliegt.

Ein Ausgang 116 des Multiplexers 108 ist ebenfalls mit dem Zuverlässigkeitswert-Speicher 113 gekoppelt.

Von der Steuerungseinheit 702 wird die Zuverlässigkeitswert-Ermittlungseinheit 706 derart gesteuert, dass jeweils für einen Zeitpunkt k und einen Zustand m auf dem Maximum-Likelihood-Pfad der erste Zuverlässigkeitswert von einer Subtraktionseinheit 117 gebildet wird und als erster Zuverlässigkeitswert S(k) für die jeweilige Iteration, in der der Zeitschritt k den Zeitschritt beschreibt, in dem der jeweilige Teilendzustand liegt, gespeichert wird.

Ferner sind in dem Zuverlässigkeitswert-Speicher 113 die gemäß dem oben beschriebenen Verfahren ermittelten Zuverlässigkeitswerte bzw. Zwischen-Zuverlässigkeitswerte S(k-i) gespeichert.

Die entsprechenden Gesamtmetriken für den jeweiligen Teilendzustand entlang des Maximum-Likelihood-Pfads 501 werden der Zuverlässigkeitswert-Ermittlungseinheit 706 von der Endzustands-Metrik-Ermittlungseinheit 705 zugeführt.

Ist der erste Zuverlässigkeitswert S(k) zum Zeitpunkt k ermittelt, wählt die Steuerungseinheit 702 nicht aktualisierte Zuverlässigkeitswerte S(k-i) zum Zeitpunkt k-i aus und führt diese dem ersten Eingang 112 der Minimum-Auswahleinheit 111 zu.

Der erste Zuverlässigkeitswert S(k) wird dem zweiten Eingang 114 der Minimum-Auswahleinheit 111 zugeführt.

Somit liegt an dem Ausgang 110 der Minimum-Auswahleinheit 111 und damit auch an dem ersten Eingang 109 des Multiplexers 108 das Minimum aus den beiden Zuverlässigkeitswerten an.

An dem zweiten Eingang 115 des Multiplexers 108 liegt der Zuverlässigkeitswert S(k-i) an.

Ergibt sich aufgrund der mittels des Exklusiv-ODER-Gatters 105 ermittelten Überprüfung, dass die beiden ausgewählten Bits aus dem ersten Register 101 und dem zweiten Register 102 sich unterscheiden, so wird der Multiplexer 108 durch das Ausgangssignal des Exklusiv-ODER-Gatters 105 derart geschaltet, dass das an dem ersten Eingang 109 des Multiplexers 108 anliegende Signal an den Ausgang 116 des Multiplexers 108 durchgeschaltet wird und dieser Wert den vorangegangenen, an dem ersten Eingang 112 der Minimum-Auswahleinheit 111 anliegenden Zuverlässigkeitswert S(k-i) ersetzt als aktualisierter Zuverlässigkeitswert S(k-i)_upd.

Der Zuverlässigkeitswert-Speicher 113 ist über den Bus 722 mit dem vierten Speicherbereich 721 gekoppelt, so dass nach Durchführen des zweiten "Durchlaufs" des Viterbi-Algorithmus die ermittelten Zuverlässigkeitswerte in dem vierten Speicherbereich 721 abgespeichert werden.

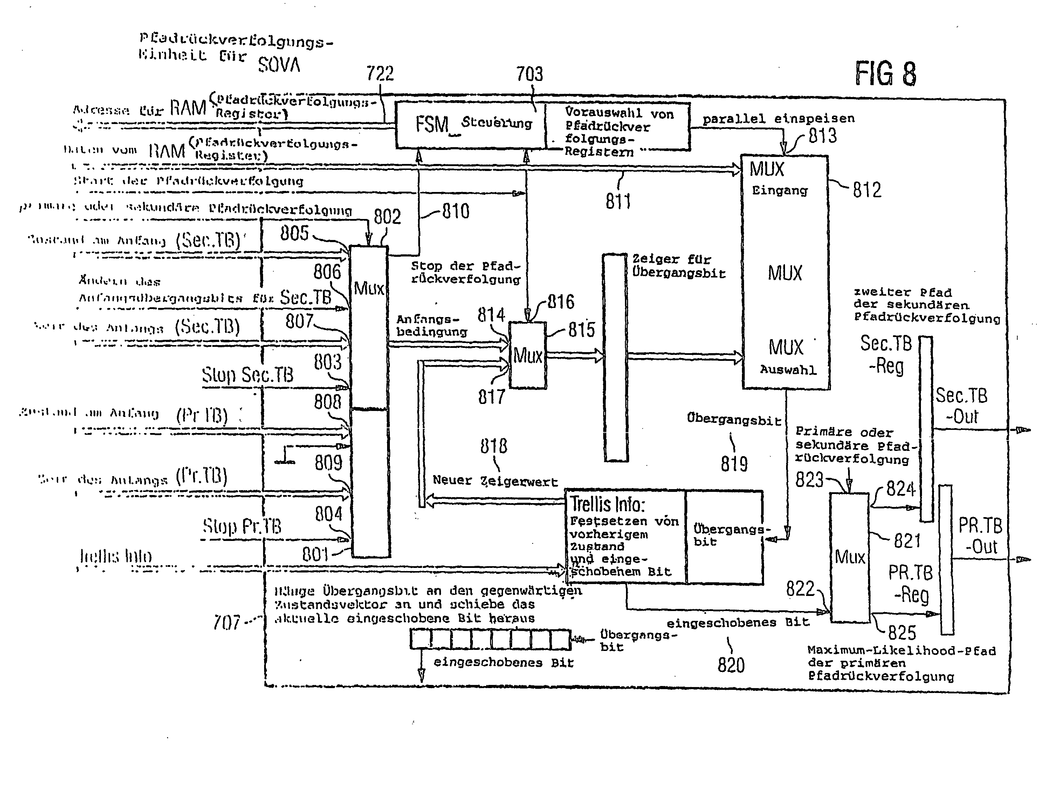

In **Fig.8** ist die Pfadrückverfolgungs-Einheit 707 im Detail dargestellt.

Mit der Pfadrückverfolgungs-Einheit können sowohl der Maximum-Likelihood-Pfad als auch die weiteren konkurrierenden Pfade rückverfolgt werden. Dementsprechend gibt es Eingangssignale, die Bezug auf beide Pfadtypen nehmen und der internen Logik gemultiplext zugeführt werden können.

Die Pfadrückverfolgungs-Einheit 707 weist einen ersten Multiplexer 801 auf, der über einen Steuereingang 802 mit der Steuerungseinheit 702 gekoppelt ist (vgl. **Fig.7**). Über den Steuereingang 802 wird ausgewählt, ob durch den ersten Multiplexer 801 Information über den Maximum-Likelihood-Pfad 501 oder den jeweils weiteren konkurrierenden Pfad ausgewählt wird. Über einen ersten Stopp-Eingang 803 wird ein Stopsignal zum Stoppen der Verarbeitung von Information über den weiteren Pfad dem Multiplexer 801 zugeführt. Über einen zweiten Stopp-Eingang 804 wird dem Multiplexer 801 ein Stopsignal zum Stoppen der Verarbeitung von Informationen über den Maximum-Likelihood-Pfad 501 zugeführt.

An einem ersten Eingang 805 wird dem Multiplexer 801 der jeweilige Start-Zustand für das Pfadrückverfolgungs-Verfahren innerhalb des weiteren Pfades zugeführt.

Die Information, ob das erste Übergangsbit bei der Rückverfolgung des weiteren Pfades invertiert werden muss, wird dem ersten Multiplexer 801 über einen zweiten Eingang 806 zugeführt. Der zweite Eingang 806 ist aktiv beim Start des Rückverfolgungs-Verfahrens über den konkurrierenden Pfad und inaktiv während des weiteren Rückverfolgungs-Verfahrens.

Über einen dritten Eingang 807 wird dem ersten Multiplexer 801 der jeweilige Zeitpunkt k, auf den sich der Start-Zustand bezieht, zugeführt.

Über einen vierten Eingang 808 wird dem ersten Multiplexer 801 der Start-Zustand des Maximum-Likelihood-Pfads 501 zugeführt.

Über einen fünften Eingang 809 wird der Zeitpunkt, auf den sich der Start-Zustandes des Maximum-hikelihood-Pfads 501 bezieht, dem ersten Multiplexer 801 zugeführt.

Von dem ersten Multiplexer 801 wird ein Stoppsignal 810 der Steuerungseinheit 703 zugeführt, mit dem das Beenden des Pfadrückverfolgungs-Verfahrens angezeigt wird.

Von der Steuerungseinheit 703 wird die Adresse des jeweils auszulesenden Pfadrückverfolgungs-Registers 715 innerhalb des ersten Speicherbereichs 716 erzeugt und die entsprechenden Bits des ausgewählten Pfadrückverfolgungs-Registers 715 werden aus dem RAM als Eingangsdaten 811 eingelesen und einem zweiten Multiplexer 812 zugeführt.

Der zweite Multiplexer 812 wird über einen Steuereingang 813 durch die Steuerungseinheit 703 gesteuert. Die Startbedingungen, die von dem ersten Multiplexer 801 ausgewählt werden, das heißt der jeweilige Start-Zustand und der jeweilige Start-Zeitpunkt werden einem ersten Eingang 814 eines dritten Multiplexers 815 zugeführt.

Der dritte Multiplexer 815 bekommt somit die Startinformation von dem Maximum-Likelihood-Pfad oder von dem konkurrierenden Pfad.

Der dritte Multiplexer 815 wird über einen Steuereingang 816 des dritten Multiplexers 816 durch die Steuerungseinheit 703 gesteuert.

Die Startbedingungen am Eingang 814 des dritten Multiplexers 815 selektieren ein Bit aus dem Pfadrückverfolgungsregister für den Startzeitpunkt gemäß der **Fig.4** (403), das als "traceback value" bzw. als "transition bit" bezeichnet, von rechts an den aktuellen Zustands-Vektor angehängt wird und damit den neuen Zeigerwert 818 bildet.

Von nun an selektieren die jeweils in jedem Zeitschritt ergänzten Zeiger das "transition bit" des jeweils vorangegangenen Zeitschrittes.

An einem zweiten Eingang 817 des dritten Multiplexers 815 liegt ein Wert an, der dem jeweils neuen Zeigerwert 818 des zeitlich vorangegangenen Zeitschritts und Zustandes in der Trellis 500 gemäß dem in den zweiten Multiplexer 812 geladenen Pfadrückverfolgungs-Register 715 und dem zugehörigen, durch den Zeiger für die Ermittlung des Übergangsbits 819 ermittelten Übergangsbit darstellt.

Die Pfadrückverfolgungs-Einheit benötigt Informationen über das verwendete Kodierverfahren, wie beispielsweise die Anzahl der Zustände und damit die Anzahl der Bits in dem Zustandsvektor. Diese Information wird sowohl bei der Erstellung des neuen Zeigerwertes als auch bei der Vorselektion der Pfadrückverfolgungs-Register 715 (Größe der Pfadrückverfolgungs-Register 715) benötigt.

Das gemäß dem oben beschriebenen Pfadrückverfolgungs-Verfahren herausgeschobene Bit dient als dekodiertes Bit, das den entsprechenden Signalwert auf dem Maximum-Likelihood-Pfad oder dem weiteren Pfad entspricht.

Das dekodierte Bit 820, das heißt das aus dem entsprechenden Schieberegister herausgeschobene Bit wird einem Eingang 822 eines vierten Multiplexer 821 zugeführt.

Abhängig von einem Steuersignal an einem Steuereingang 823 des vierten Multiplexers 821 wird das Bit einem ersten Ausgang 824 oder einem zweiten Ausgang 825 zugeführt. Wird das Bit dem ersten Ausgang 824 zugeführt, so bedeutet dies, dass das Bit dem weiteren Pfad zugeordnet ist. Wird das Bit dem zweiten Ausgang 825 zugeführt, so bedeutet dies, dass das Bit dem Maximum-Likelihood-Pfad zugeordnet wird.

Die Steuerungseinheit 702 ist derart eingerichtet, dass die oben beschriebenen Verfahrensschritte mit der Zuverlässigkeitswert-Ermittlungseinheit 706 und den entsprechenden weiteren Einheiten der Viterbi-Dekodiereinheit 700 durchgeführt werden können.

In diesem Dokument sind folgende Veröffentlichungen zitiert:

[1] G.D. Forney, The Viterbi-Algorithm, Proceedings of the IEEE, Vol. 61, Nr. 3, S. 268 - 278, 1973

[2] J. Hagenauer, P. Hoeher, A Viterbi Algorithm with Soft-Decision Outputs and its Applications, S. 1680 - 1686, GLOBECOM, 1989

[3] J. Hagenauer, Source-Controlled Channel Decoding, IEEE Transaction on Communications, Vol. 43, Nr. 9, S. 2449 - 2457, September 1995

[4] C. Berrou et al, A Low Complexity Soft-Output Viterbi Decoder Architecture, ICC 93.

[5] US 5 406 570

[6] Patent Abstracts of Japan JP 11186914 A

[7] US 5 784 392

**Bezugszeichenliste**

101    erstes Register
102    zweites Register
103    erste Kopplung
104    zweite Kopplung
105    Vergleichseinheit
106    Ausgang Vergleichseinheit
107    Steuereingang Multiplexer
108    Multiplexer
109    erster Eingang Multiplexer
110    Ausgang Minimum-Auswahleinheit
111    Minimum-Auswahleinheit
112    erster Eingang Minimum-Auswahleinheit
113    Zuverlässigkeitswert-Speicher
114    zweiter Eingang Minimum-Auswahleinheit
115    zweiter Eingang Multiplexer

| | |
|---|---|
| 116 | Ausgang Multiplexer |
| | |
| 200 | Sender |
| 201 | Quelle |
| 202 | Nachricht |
| 203 | Quellencodierer |
| 204 | Codewort |
| 205 | Einheit zur Kanalcodierung |
| 206 | Kanalcodewort |
| 207 | Einheit zur Modulation 207 des Kanalcodewortes |
| 208 | Physikalischer Kanal |
| 209 | Moduliertes Signal |
| 210 | Störung |
| 211 | Empfänger |
| 212 | Verändertes moduliertes Signal |
| 213 | Einheit zur Demodulation |
| 214 | Elektrisches Signal |
| 215 | Einheit zur Kanaldecodierung |
| 216 | Rekonstruiertes Codewort |
| 217 | Quellendecodierung |
| 218 | Decodiertes Signal |
| 219 | Senke |
| | |
| 300 | Butterfly-Struktur |
| 301 | erster Anfangszustand |
| 302 | zweiter Anfangszustand |
| 303 | Zustandsübergangspfeil |
| 304 | Zustandsübergangspfeil |
| 305 | Zustandsübergangspfeil |
| 306 | Zustandsübergangspfeil |
| 307 | erster Endzustand |
| 308 | zweiter Endzustand |
| | |
| I1 | erste Zustandsübergangsmetrik |
| I2 | zweite Zustandsübergangsmetrik |
| I3 | dritte Zustandsübergangsmetrik |
| I4 | vierte Zustandsübergangsmetrik |
| | |
| 401 | Startzustand Pfadrückverfolgungsverfahren |
| 402 | Zeiger auf Bit in Pfadrückverfolgungsregister für Zeitpunkt k |
| 403 | Bit in Pfadrückverfolgungsregister für Zeitpunkt k |
| 404 | Pfadrückverfolgungsregister für Zeitpunkt k |
| 405 | decodierter Signalwert Zeitpunkt k |
| 406 | Pfadrückverfolgungszustand zu Zeitpunkt k-1 |
| 407 | Zeiger auf Bit in Pfadrückverfolgungsregister für Zeitpunkt k-1 |
| 408 | Pfadrückverfolgungsregister für Zeitpunkt k-1 |
| 409 | Bit in Pfadrückverfolgungsregister für Zeitpunkt k-1 |
| 410 | decodierter Signalwert Zeitpunkt k-1 |
| | |
| 500 | Trellis |
| 501 | Maximum-Likelihood-Pfad |
| 502 | Zustände in Trellis |
| 503 | Teilbereich |
| 504 | Teilendzustand |
| | |
| 505 | vorangegangener Zustand zu Teilendzustand auf Maximum-Likelihood-Pfad |
| 506 | zweiter Pfad |
| 507 | Zustände zweiter Pfad |

| | |
|---|---|
| 508 | Pfeil |

| | |
|---|---|
| Pr.TB(k-j) | Übergangsbit auf Maximum-Likelihood-Pfad |
| Sec.TB(k-j) | Übergangsbit auf zweitem Pfad |

| | |
|---|---|
| 601 | Erster Teilbereich |
| 602 | Erster Zweig Maximum-Likelihood-Pfad |
| 603 | Erster Teilendzustand |
| 604 | Zweiter Pfad |
| 605 | Zweig zweiter Pfad |
| 606 | Zweiter Teilbereich |
| 607 | Zweiter Teilendzustand |
| 608 | Dritter Pfad |
| 609 | Zustand dritter Pfad |
| 610 | Zustand dritter Pfad |
| 611 | Dritter Teilbereich |
| 612 | Dritter Teilendzustand |
| 613 | Vierter Pfad |
| 614 | Zustand vierter Pfad |
| 615 | Zustand vierter Pfad |
| 616 | Zustand vierter Pfad |
| 617 | Erster Zweig Maximum-Likelihood-Pfad |
| 618 | Zweiter Zweig Maximum-Likelihood-Pfad |
| 619 | Vierter Teilbereich |
| 620 | Vierter Teilendzustand |
| 621 | Fünfter Pfad |
| 622 | Zustand fünfter Pfad |
| 623 | Zustand fünfter Pfad |
| 624 | Zustand fünfter Pfad |
| 625 | Zustand fünfter Pfad |

| | |
|---|---|
| 700 | Viterbi-Decodiereinheit |
| 701 | Takteingang |
| 702 | Steuerungseinheit |
| 703 | Signalempfangsspeicher |
| 704 | Metrik-Ermittlungseinheit |
| 705 | Endzustands-Ermittlungseinheit |
| 706 | Zuverlässigkeitswert-Ermittlungseinheit |
| 707 | Pfadrückverfolgungseinheit |
| 708 | Speicher |
| 709 | Addierer |
| 710 | Addierer |
| 711 | Addierer |
| 712 | Addierer |
| 713 | Maximum-Auswahleinheit |
| 714 | Maximum-Auswahleinheit |
| 715 | Pfadrückverfolgungsregister |
| 716 | Erster Speicherbereich |
| 717 | Zweiter Speicherbereich |
| 718 | Erste Kopplung |
| 719 | Zweite Kopplung |
| 720 | Dritter Speicherbereich |
| 721 | Vierter Speicherbereich |
| 722 | Bus |

| | |
|---|---|
| 801 | Erster Multiplexer |
| 802 | Steuereingang Multiplexer |
| 803 | Erster Stopp-Eingang |

804    Zweiter Stopp-Eingang
805    Erster Eingang erster Multiplexer
806    Zweiter Eingang erster Multiplexer
807    Dritter Eingang erster Multiplexer
808    Vierter Eingang erster Multiplexer
809    Fünfter Eingang erster Multiplexer
810    Stoppsignal
811    Eingangsdaten
812    Zweiter Multiplexer
813    Steuereingang zweiter Multiplexer
814    Erster Eingang dritter Multiplexer
815    Dritter Multiplexer
816    Steuereingang dritter Multiplexer
817    Zweiter Eingang dritter Multiplexer
818    Neuer Zeigerwert des zeitlich folgenden Zustands in Trellis
819    Übergangsbit
820    Decodiertes Bit
821    Vierter Multiplexer
822    Eingang vierter Multiplexer
823    Steuereingang vierter Multiplexer
824    Erster Ausgang vierter Multiplexer
825    Zweiter Ausgang vierter Multiplexer

901    Hälfte Trellis
902    Erster Teilbereich
903    Zweiter Teilbereich

**Patentansprüche**

1. Verfahren zum Dekodieren einer Folge physikalischer Signale,

   o    bei dem für alle physikalischen Signale ein Viterbi-Algorithmus ein erstes Mal durchgeführt wird, wodurch ein Maximum-Likelihood-Pfad entlang der gesamten sich gemäß dem Viterbi-Algorithmus ergebenden Trellis ermittelt wird, wobei zu jedem physikalischen Signal ein Signalwert ermittelt wird,

   o    bei dem für jeden gemäß dem Viterbi-Algorithmus ermittelten Signalwert des Maximum-Likelihood-Pfads ein Zuverlässigkeitswert ermittelt wird,

   o    bei dem der Viterbi-Algorithmus ein zweites Mal durchgeführt wird, wobei folgende Verfahrensschritte iterativ durchgeführt werden, bis alle Signalwerte der ermittelten Trellis berücksichtigt worden sind:

       a) es wird ein Teilbereich der Trellis ausgewählt, wobei der Teilbereich einen Teilanfangssignalwert und einen Teilendsignalwert auf dem Maximum-Likelihood-Pfad aufweist,
       b) es wird mindestens ein weiterer Pfad in dem Teilbereich der Trellis ermittelt, der in dem Teilendsignalwert des Maximum-Likelihood-Pfads endet,
       c) es wird jeder Signalwert auf dem weiteren Pfad mit jedem Signalwert auf dem Maximum-Likelihood-Pfad verglichen,
       d) es wird für jeden Signalwert auf dem Maximum-Likelihood-Pfad das Minimum aus dem dem Signalwert zugeordneten Zuverlässigkeitswert und dem Zuverlässigkeitswert des Teilendsignalwerts gebildet,
       e) es wird gemäß einem vorgegebenen Kriterium der Zuverlässigkeitswert oder das Minimum ausgewählt und dem jeweiligen Signalwert zugeordnet, und

   o    bei dem als dekodierte Folge die ermittelten Signalwerte und die den Signalwerten zugeordneten ausgewählten Zuverlässigkeitswerte verwendet werden.

2. Verfahren nach Anspruch 1,
   bei dem als Signalwert ein binärer Wert verwendet wird.

3. Verfahren nach Anspruch 1 oder 2,

bei dem mindestens ein Anfangssignalwert zu Beginn der Folge physikalischer Signale und/oder mindestens ein Endsignalwert am Ende der Folge physikalischer Signale vorgegeben wird.

4. Verfahren nach einem der Ansprüche 1 bis 3,
   bei dem jeweils als Teilbereich der Trellis ein Bereich ausgewählt wird, der eine vorgegebene Anzahl von Signalwerten aufweist.

5. Verfahren nach Anspruch 4,
   bei dem jeweils als Teilbereich der Trellis eine Anzahl von Signalwerten verwendet wird, die abhängig ist von der Rückgrifftiefe des verwendeten Faltungspolynoms.

6. Verfahren nach einem der Ansprüche 1 bis 5,
   bei dem der weitere Pfad auf folgende Weise ermittelt wird:

   o  das Übergangsbit, das zu dem Teilendsignalwert gemäß dem Maximum-Likelihood-Pfad geführt hat, wird invertiert,
   o  mittels Pfadrückverfolgungs-Information, die beim ersten Durchführen des Viterbi-Algorithmus oder beim aktuellen Durchführen des Viterbi-Algorithmus ermittelt worden ist, wird ein Pfadrückverfolgungsverfahren durchgeführt, wobei von dem Teilendsignalwert ausgegangen wird und mit dem invertierten Übergangsbit das erneute Pfadrückverfolgungsverfahren begonnen wird.

7. Verfahren nach einem der Ansprüche 1 bis 6,
   bei dem als Zuverlässigkeitswert die Differenz von akkumulierten Signalwertmetriken verwendet werden, die gemäß dem Viterbi-Algorithmus gebildet werden.

8. Verfahren nach Anspruch 7,
   bei dem jeweils für den Signalwert die Differenz von akkumulierten Signalwertmetriken oder das Minimum aus Zuverlässigkeitswert und dem Zuverlässigkeitswert des Teilendsignalwertes ausgewählt wird und dem Signalwert zugeordnet wird.

9. Zuverlässigkeitswert-Ermittlungseinheit zum Ermitteln eines Zuverlässigkeitswerts im Rahmen eines Viterbi-Algorithmus, mit

   o  einem ersten Pfadspeicher zum Speichern von Signalwerten eines Maximum-Likelihood-Pfads gemäß dem Viterbi-Algorithmus,
   o  einem zweiten Pfadspeicher zum Speichern von Signalwerten eines weiteren Pfades gemäß dem Viterbi-Algorithmus,
   o  einer mit dem ersten Pfadspeicher und dem zweiten Pfadspeicher gekoppelten ersten Auswahleinheit zum Auswählen von Signalwerten aus dem ersten Pfadspeicher und dem zweiten Pfadspeicher,
   o  einer mit der ersten Auswahleinheit gekoppelten Vergleichseinheit zum Vergleichen der ausgewählten Signalwerte aus dem ersten Pfadspeicher und dem zweiten Pfadspeicher,
   o  einer zweiten Auswahleinheit, die aufweist

      a) einen Steuereingang, der mit dem Ausgang der Vergleichseinheit gekoppelt ist,
      b) einen ersten Eingang, der mit dem Ausgang einer dritten Auswahleinheit gekoppelt ist,
      c) einem zweiten Eingang,

   o  einem Zuverlässigkeitswert-Speicher zum Speichern von Zuverlässigkeitswerten,
   o  einer Steuereinheit, die derart eingerichtet ist, dass

      a) aus dem Zuverlässigkeitswert-Speicher ein zuvor ermittelter und gespeicherter erster Zuverlässigkeitswert, der einem Signalwert auf dem Maximum-Likelihood-Pfad zugeordnet ist, einem ersten Eingang der dritten Auswahleinheit zuführbar ist,
      b) aus dem Zuverlässigkeitswert-Speicher ein zuvor ermittelter und gespeicherter zweiter Zuverlässigkeitswert, der einem Signalwert auf dem Maximum-Likelihood-Pfad zugeordnet ist, einem zweiten Eingang der dritten Auswahleinheit zuführbar ist,
      c) der erste Zuverlässigkeitswert dem zweiten Eingang der zweiten Auswahleinheit zuführbar ist,
      d) der von der zweiten Auswahleinheit ausgewählte Wert als erster Zuverlässigkeitswert speicherbar ist,

o wobei bei Ungleichheit der ausgewählten Signalwerte aus dem ersten Pfadspeicher und dem zweiten Pfadspeicher von der Vergleichseinheit ein Steuersignal der zweiten Auswahleinheit zuführbar ist derart, dass von der zweiten Auswahleinheit der an ihrem ersten Eingang anliegende, von der dritten Auswahleinheit ausgewählte Zuverlässigkeitswert auswählbar ist.

10. Zuverlässigkeitswert-Ermittlungseinheit nach Anspruch 9, bei der die Steuereinheit derart eingerichtet ist, dass aus dem Zuverlässigkeitswert-Speicher ein zuvor ermittelter und gespeicherter zweiter Zuverlässigkeitswert, der dem Teilendsignalwert auf dem Maximum-Likelihood-Pfad zugeordnet ist, dem zweiten Eingang der dritten Auswahleinheit zuführbar ist,

11. Zuverlässigkeitswert-Ermittlungseinheit nach Anspruch 9 oder 10,
bei der zweite Auswahleinheit ein Multiplexer ist.

12. Zuverlässigkeitswert-Ermittlungseinheit nach einem der Ansprüche 9 bis 11,
bei der die erste Auswahleinheit derart eingerichtet ist, dass jeweils Signalwerte einer gleichen Zeiteinheit ausgewählt werden.

13. Zuverlässigkeitswert-Ermittlungseinheit nach einem der Ansprüche 9 bis 12,
bei der die dritter Auswahleinheit derart eingerichtet ist, dass sie den kleineren Zuverlässigkeitswert aus dem ersten Zuverlässigkeitswert und dem zweiten Zuverlässigkeitswert auswählt.

14. Zuverlässigkeitswert-Ermittlungseinheit nach einem der Ansprüche 9 bis 13,
bei der die Steuereinheit derart eingerichtet ist, dass iterativ die Zuverlässigkeitswerte aller Signalwerte des Maximum-Likelihood-Pfads als erster Zuverlässigkeitswert dem ersten Eingang der dritten Auswahleinheit zuführbar sind.

15. Viterbi-Dekodiereinheit mit einer Zuverlässigkeitswert-Ermittlungseinheit nach einem der Ansprüche 9 bis 14.

16. Vorrichtung zum Dekodieren einer Folge physikalischer Signale,
mit einem Prozessor, der derart eingerichtet ist, dass folgende Verfahrensschritte durchführbar sind:

o für alle physikalischen Signale wird gemäß einem ersten Durchführen eines Viterbi-Algorithmus ein Maximum-Likelihood-Pfad entlang der gesamten sich gemäß dem Viterbi-Algorithmus ergebenden Trellis ermittelt, wodurch zu jedem physikalischen Signal ein Signalwert ermittelt wird,

o für jeden gemäß dem Viterbi-Algorithmus ermittelten Signalwert des Maximum-Likelihood-Pfads wird ein Zuverlässigkeitswert ermittelt,

o der Viterbi-Algorithmus wird ein zweites Mal durchgeführt, wobei folgende Verfahrensschritte iterativ durchgeführt werden, bis alle Signalwerte der ermittelten Trellis berücksichtigt worden sind:

a) es wird ein Teilbereich der Trellis ausgewählt, wobei der Teilbereich einen Teilanfangssignalwert und einen Teilendsignalwert auf dem Maximum-Likelihood-Pfad aufweist,
b) es wird mindestens ein weiterer Pfad in dem Teilbereich der Trellis ermittelt, der in dem Teilendsignalwert des Maximum-Likelihood-Pfads endet,
c) es wird jeder Signalwert auf dem weiteren Pfad mit jedem Signalwert auf dem Maximum-Likelihood-Pfad verglichen,
d) es wird für jeden Signalwert auf dem Maximum-Likelihood-Pfad das Minimum aus dem dem Signalwert zugeordneten Zuverlässigkeitswert und dem Zuverlässigkeitswert des Teilendsignalwerts gebildet,
e) es wird gemäß einem vorgegebenen Kriterium der Zuverlässigkeitswert oder das Minimum ausgewählt und dem jeweiligen Signalwert zugeordnet, und

o als dekodierte Folge werden die ermittelten Signalwerte und die den Signalwerten zugeordneten ausgewählten Zuverlässigkeitswerte verwendet.

17. Vorrichtung nach Anspruch 16,

o mit einer Übergangs-Metrik-Ermittlungseinheit zum Ermitteln einer Übergangs-Metrik,
o mit einer mit der Übergangs-Metrik-Ermittlungseinheit gekoppelten Endzustands-Metrik-Ermittlungseinheit zum Ermitteln einer Endzustands-Metrik,

o  mit einer mit der Endzustands-Metrik-Ermittlungseinheit gekoppelten Zuverlässigkeitswert-Ermittlungseinheit,

o  mit einer mit der Zuverlässigkeitswert-Ermittlungseinheit und der Endzustands-Metrik-Ermittlungseinheit gekoppelten Pfadrückverfolgungs-Einheit zum Ermitteln von Pfadrückverfolgungsinformation.

**18.** Vorrichtung nach Anspruch 16 oder 17, mit einem Speicher

o  mit einem ersten Speicherbereich zum Speichern von Pfadrückverfolgungs-Informationen, und/oder

o  mit einem zweiten Speicherbereich zum Speichern von Soft-Eingangsinformationen für die Dekodiereinheit, und/oder

o  mit einem dritten Speicherbereich zum Speichern von ermittelten Zustandsmetriken und Zustandsübergangsmetriken, und/oder

o  mit einem vierten Speicherbereich zum Speichern von zur Ausgabe vorgesehenen Signalwerten und den Signalwerten zugeordneten Zuverlässigkeitswerten.

**19.** Vorrichtung nach Anspruch 18,
bei der zumindest einer der Speicherbereiche als RAM ausgestaltet ist.

**20.** Vorrichtung nach einem der Ansprüche 17 bis 19,
bei der die Pfadrückverfolgungs-Einheit folgende Komponenten aufweist:

o  eine Steuerungseinheit 702

o  einen Multiplexer, der über einen Steuereingang mit der Steuerungseinheit gekoppelt ist,

-  wobei über den Steuereingang ausgewählt werden kann, ob durch den ersten Multiplexer Information über den Maximum-Likelihood-Pfad oder den jeweils weiteren konkurrierenden Pfad ausgewählt wird,

-  wobei an einem ersten Eingang des ersten Multiplexers der jeweilige Start-Zustand für das Pfadrückverfolgungs-Verfahren innerhalb des weiteren konkurrierenden Pfades zuführbar ist,

-  wobei an einem zweiten Eingang des ersten Multiplexers Information zuführbar ist darüber, ob ein Übergangsbit bei der Rückverfolgung des weiteren Pfades invertiert werden soll,

-  wobei an einem dritten Eingang des ersten Multiplexers der jeweilige Zeitpunkt, auf den sich der Start-Zustand bezieht, zuführbar ist,

-  wobei an einem vierten Eingang des ersten Multiplexers der jeweilige Start-Zustand des Maximum-Likelihood-Pfads zuführbar ist, und

-  wobei an einem fünften Eingang des ersten Multiplexers der jeweilige Zeitpunkt, auf den sich der Start-Zustand des Maximum-Likelihood-Pfads bezieht, zuführbar ist.

**Claims**

**1.** A method for decoding a sequence of physical signals,

•  in which a Viterbi algorithm is carried out a first time for all physical signals, as a result of which a maximum likelihood path is determined along the entire trellis which trellis results according to the Viterbi algorithm, wherein a signal value is determined for each physical signal,

•  in which a reliability value is determined for each signal value determined according to the Viterbi algorithm of the maximum likelihood path,

•  in which the Viterbi algorithm is carried out a second time, with the following method steps being carried out iteratively until all the signal values of the determined trellis have been taken into account:

a) one subregion of the trellis is selected, wherein the subregion has a partial initial signal value and a partial end signal value on the maximum likelihood path,
b) at least one further path is determined in the subregion of the trellis which further path ends at the partial end signal value of the maximum likelihood path,
c) each signal value on the further path is compared with each signal value on the maximum likelihood path,
d) the minimum of the reliability value associated with the signal value and of the reliability value of the partial end signal value is formed for each signal value on the maximum likelihood path,
e) the reliability value or the minimum is selected and is associated with the respective signal value according to a predetermined criterion, and

- in which the determined signal values and the selected reliability values associated with the signal values are used as decoded sequence.

2. The method according to claim 1, in which a binary value is used as the signal value.

3. The method according to claim 1 or 2, in which at least one initial signal value is predetermined at the start of the sequence of physical signals and/or at least one end signal value is predetermined at the end of the sequence of physical signals.

4. The method according toone of the claims 1 to 3, in which an area which has a predetermined number of signal values is in each case selected as the subregion of the trellis.

5. The method according to claim 4, in which in each case a number of signal values are used as subregion of the trellis, which number is dependent on the reversion depth of the convolution polynomial that is used.

6. The method according to one of the claims 1 to 5, in which the further path is determined in the following way:

   - the transition bit which has led to the partial end signal value according to the maximum likelihood path is inverted,
   - a path traceback method is carried out by means of path traceback information which was determined during the first run of the Viterbi algorithm or during the current run of the Viterbi algorithm, starting from the partial end signal value, and wherein the renewed path traceback method is started with the inverted transition bit.

7. The method according to one of the claims 1 to 6, in which the difference between accumulated signal value metrics which are formed according to the Viterbi algorithm is used as reliability value.

8. The method according to claim 7, in which the difference between accumulated signal value metrics or the minimum of the reliability value and the reliability value of the partial end signal value is in each case chosen for the signal value, and is associated with the signal value.

9. A reliability value determining unit for determining a reliability value in the course of a Viterbi algorithm, having

   - a first path memory for storing signal values of a maximum likelihood path according to the Viterbi algorithm,
   - a second path memory for storing signal values of a further path according to the Viterbi algorithm,
   - a first selection unit, which is coupled to the first path memory and to the second path memory, for selecting signal values from the first path memory and from the second path memory,
   - a comparison unit, which is coupled to the first selection unit, for comparing the selected signal values from the first path memory and from the second path memory,
   - a second selection unit which has,

     a) a control input which is coupled to the output of the comparison unit,
     b) a first input which is coupled to the output of a third selection unit,
     c) a second input,

   - a reliability value memory for storing reliability values,
   - a control unit which is set up such that

     a) a previously determined and stored first reliability value, which is associated with a signal value on the maximum likelihood path, can be supplied from the reliability value memory to a first input of the third selection unit,
     b) a previously determined and stored second reliability value which is associated with a signal value on the maximum likelihood path can be supplied from the reliability value memory to a second input of the third selection unit,
     c) the first reliability value can be supplied to the second input of the second selection unit,
     d) the value which is selected by the second selection unit can be stored as the first reliability value,

- wherein, in case of an inequality of the selected signal values from the first path memory and from the second path memory , the comparison unit can supply a control signal to the second selection unit such that the second selection unit can select the reliability value which is applied to its first input and has been selected by the third selection unit.

10. The reliability value determining unit according to claim 9, in which the control unit is set up such that a previously determined and stored second reliability value, which is associated with the partial end signal value of the maximum likelihood path, can be supplied from the reliability value memory to the second input of the third selection unit.

11. The reliability value determining unit according to claim 9 or 10,
   in which the second selection unit is a multiplexer.

12. The reliability value determining unit according to one of the claims 9 to 11,
   in which the first selection unit is set up such that signal values are in each case selected for an identical time unit.

13. The reliability value determining unit according to one of the claims 9 to 12,
   in which the third selection unit is set up such that it selects the lower reliability value of the first reliability value and the second reliability value.

14. The reliability value determining unit according to one of the claims 9 to 13,
   in which the control unit is set up such that the reliability values of all the signal values of the maximum likelihood path can be supplied iteratively as the first reliability value to the first input of the third selection unit.

15. A Viterbi decoding unit having a reliability value determining unit as claimed in one of the claims 9 to 14.

16. A device for decoding a sequence of physical signals, having a processor which is set up such that the following method steps can be carried out:

   - for all the physical signals a maximum likelihood path along the entire trellis which trellis results according to the Viterbi algorithm is determined according to a first run of a Viterbi algorithm, as a result of which one signal value is determined for each physical signal,
   - a reliability value is determined for each signal value of the maximum likelihood path determined according to the Viterbi algorithm,
   - the Viterbi algorithm is carried out a second time, with the following method steps being carried out iteratively until all the signal values of the determined trellis have been taken into account:

     a) one subregion of the trellis is selected, with the subregion having a partial initial signal value and a partial end signal value on the maximum likelihood path,
     b) at least one further path is determined in that subregion of the trellis which ends at the partial end signal value of the maximum likelihood path,
     c) each signal value on the further path is compared with each signal value on the maximum likelihood path,
     d) the minimum of the reliability value associated with the signal value and of the reliability value of the partial end signal value is formed for each signal value on the maximum likelihood path,
     e) according to a predetermined criterion, the reliability value or the minimum is selected and is associated with the respective signal value and

   - the determined signal values and the selected reliability values associated with the signal values are used as the decoded sequence.

17. The device according to claim 16,

   - having a transition metrics determining unit for determining a transition metric,
   - having an end state metric determining unit, which is coupled to the transition metric determining unit, for determining an end state metric,
   - having a reliability value determining unit which is coupled to the end state metric determining unit, and
   - having a path traceback unit, which is coupled to the reliability value determining unit and to the end state detection metric determining unit, for determining path traceback information.

**18.** The device according to claim 16 or 17, having a memory

- with a first memory area for storing path traceback information and/or
- with a second memory area for storing soft input information for the decoding unit and/or
- with a third memory area for storing determined state metrics and state transition metrics and/or
- with a fourth memory area for storing signal values which are intended to be output, and reliability values associated with the signal values.

**19.** The device according to claim 18, in which at least one of the memory areas is in the form of RAM.

**20.** The device according to one of the claims 17 to 19, in which the path traceback unit has the following components:

- a control unit 702,
- a multiplexer which is coupled via a control input to the control unit,

  - wherein it is possible to to select via the control input whether information about the maximum likelihood path or about the respective further competing path is selected by the first multiplexer,
  - wherein the respective start state for the path traceback method within the further competing path can be supplied at a first input of the first multiplexer,
  - wherein information as to whether a transition bit should be inverted for the traceback of the further path can be supplied at a second input of the first multiplexer,
  - wherein the respective time to which the start state relates can be supplied at a third input of the first multiplexer,
  - in which case the respective start state of the maximum likelihood path can be supplied at a fourth input of the first multiplexer, and
  - wherein the respective time to which the start state of the maximum likelihood path relates can be supplied at a fifth input of the first multiplexer.

**Revendications**

**1.** Procédé pour décoder une suite de signaux physiques,

- dans lequel, pour tous les signaux physiques, un algorithme de Viterbi est exécuté une première fois, pour définir de la sorte un chemin de vraisemblance maximale le long de l'ensemble du treillis obtenu selon l'algorithme de Viterbi, en déterminant une valeur de signal pour chaque signal physique,
- dans lequel une valeur de fiabilité est déterminée pour chaque valeur de signal définie selon l'algorithme de Viterbi du chemin de vraisemblance maximale,
- dans lequel l'algorithme de Viterbi est exécuté une deuxième fois, les étapes suivantes du procédé étant réalisées par itération jusqu'à ce que toutes les valeurs de signaux du treillis déterminé aient été prises en compte :

  a) une zone partielle du treillis est choisie, la zone partielle présentant une valeur partielle de signal de départ et une valeur partielle de signal de fin sur le chemin de vraisemblance maximale,
  b) on détermine au moins un autre chemin dans la zone partielle du treillis qui se termine par la valeur partielle de signal de fin du chemin de vraisemblance maximale,
  c) chaque valeur de signal sur l'autre chemin est comparée à chaque valeur de signal sur le chemin de vraisemblance maximale,
  d) pour chaque valeur de signal sur le chemin de vraisemblance maximale, on forme le minimum entre la valeur de fiabilité affectée à la valeur de signal et la valeur de fiabilité de la valeur partielle de signal de fin,
  e) on choisit la valeur de fiabilité ou le minimum selon un critère prédéterminé et on l'affecte à la valeur de signal respective, et

- dans lequel sont utilisées sous la forme d'une suite décodée les valeurs de signaux déterminées et les valeurs de fiabilité sélectionnées affectées aux valeurs de signaux.

**2.** Procédé selon la revendication 1, dans lequel une valeur binaire est utilisée comme valeur de signal.

3. Procédé selon la revendication 1 ou 2, dans lequel on donne à l'avance au moins une valeur de signal de départ, au début de la suite de signaux physiques, et/ou au moins une valeur de signal de fin, à la fin de la suite de signaux physiques.

4. Procédé selon l'une quelconque des revendications 1 à 3, pour lequel on choisit comme zone partielle du treillis une zone présentant un nombre prédéterminé de valeurs de signaux.

5. Procédé selon la revendication 4, dans lequel on utilise, comme zone partielle du treillis, un nombre de valeurs de signaux dépendant de la profondeur de régression du polynôme de convolution utilisé.

6. Procédé selon l'une quelconque des revendications 1 à 5, dans lequel l'autre chemin est déterminé de la manière suivante :

- le bit de transition, qui a mené à la valeur partielle de signal de fin selon le chemin de vraisemblance maximale, est inversé,
- au moyen d'informations de traçabilité de chemin qui ont été déterminées lors de la première exécution de l'algorithme de Viterbi ou lors de l'exécution courante de l'algorithme de Viterbi, on exécute une procédure de traçabilité de chemin dans laquelle on part de la valeur partielle de signal de fin et l'on recommence la nouvelle procédure de traçabilité de chemin avec le bit de transition inversé.

7. Procédé selon l'une quelconque des revendications 1 à 6, dans lequel on utilise la différence de métriques de valeurs de signaux accumulées qui sont formées selon l'algorithme de Viterbi.

8. Procédé selon la revendication 7, dans lequel, respectivement pour la valeur de signal, on choisit la différence de métriques de valeurs de signaux accumulées ou le minimum entre la valeur de fiabilité et la valeur de fiabilité de la valeur partielle de signal de fin et on l'affecte à la valeur de signal.

9. Unité de détermination de valeurs de fiabilité pour déterminer une valeur de fiabilité dans le cadre d'un algorithme de Viterbi, comprenant :

- une première mémoire de chemins pour mémoriser les valeurs de signaux d'un chemin de vraisemblance maximale selon l'algorithme de Viterbi,
- une deuxième mémoire de chemins pour mémoriser les valeurs de signaux d'un autre chemin selon l'algorithme de Viterbi,
- une première unité de sélection couplée à la première mémoire de chemins et à la deuxième mémoire de chemins pour choisir des valeurs de signaux provenant de la première mémoire de chemins et de la deuxième mémoire de chemins,
- une unité de comparaison couplée à la première unité de sélection pour comparer les valeurs de signaux choisis provenant de la première mémoire de chemins et de la deuxième mémoire de chemins,
- une deuxième unité de sélection présentant :

  a) une entrée de commande qui est couplée à la sortie de l'unité de comparaison,
  b) une première entrée qui est couplée à la sortie d'une troisième unité de sélection,
  c) une deuxième entrée,

- une mémoire de valeurs de fiabilité pour mémoriser des valeurs de fiabilité,
- une unité de commande aménagée de sorte que

  a) on puisse acheminer de la mémoire de valeurs de fiabilité, une première valeur de fiabilité déterminée et mémorisée auparavant, qui est affectée à une valeur de signal sur le chemin de vraisemblance maximale, à une première entrée de la troisième unité de sélection,
  b) on puisse acheminer de la mémoire de valeurs de fiabilité, une deuxième valeur de fiabilité déterminée et mémorisée auparavant, qui est affectée à une valeur de signal sur le chemin de vraisemblance maximale, à une deuxième entrée de la troisième unité de sélection,
  c) que l'on puisse acheminer la première valeur de fiabilité à la deuxième entrée de la deuxième unité de sélection,
  d) que l'on puisse mémoriser la valeur choisie par la deuxième unité de sélection comme première valeur de fiabilité,

- où, en cas de non concordance des valeurs de signaux choisies de la première mémoire de chemins et de la deuxième mémoire de chemins, un signal de commande puisse être acheminé de l'unité de comparaison à la deuxième unité de sélection de sorte que l'on puisse choisir dans la deuxième unité de sélection la valeur de fiabilité appliquée à sa première entrée et choisie par la troisième unité de sélection.

10. Unité de détermination de valeurs de fiabilité selon la revendication 9, dans laquelle l'unité de commande est aménagée de sorte que l'on puisse acheminer de la mémoire de valeurs de fiabilité une deuxième valeur de fiabilité déterminée et mémorisée auparavant, qui est affectée à la valeur partielle de signal de fin sur le chemin de vraisemblance maximale, à la deuxième entrée de la troisième unité de sélection.

11. Unité de détermination de valeurs de fiabilité selon la revendication 9 ou 10, dans laquelle la deuxième unité de sélection est un multiplexeur.

12. Unité de détermination de valeurs de fiabilité selon l'une quelconque des revendications 9 à 11, dans laquelle la première unité de sélection est aménagée de sorte que des valeurs de signaux d'une même unité de temps soient respectivement choisies.

13. Unité de détermination de valeurs de fiabilité selon l'une quelconque des revendications 9 à 12, dans laquelle la troisième unité de sélection est aménagée de sorte qu'elle choisisse la plus petite valeur de fiabilité entre la première valeur de fiabilité et de la deuxième valeur de fiabilité.

14. Unité de détermination de valeurs de fiabilité selon l'une quelconque des revendications 9 à 13, dans laquelle l'unité de commande est aménagée de sorte que, par itération, les valeurs de fiabilité de toutes les valeurs de signaux du chemin de vraisemblance maximale puissent être acheminées comme première valeur de fiabilité à la première entrée de la troisième unité de sélection.

15. Unité de décodage de Viterbi avec une unité de détermination de valeurs de fiabilité selon l'une quelconque des revendications 9 à 14.

16. Dispositif pour décoder une suite de signaux physiques avec un processeur qui est aménagé de sorte que les étapes suivantes du procédé puissent être réalisées :

- pour tous les signaux physiques, on détermine, selon une première exécution d'un algorithme de Viterbi, un chemin de vraisemblance maximale le long de l'ensemble du treillis obtenu selon l'algorithme de Viterbi de manière à déterminer une valeur de signal pour chaque signal physique,
- pour chaque valeur de signal du chemin de vraisemblance maximale déterminée selon l'algorithme de Viterbi, on détermine une valeur de fiabilité,
- l'algorithme de Viterbi est exécuté une deuxième fois, les étapes suivantes du procédé étant effectuées par itération jusqu'à ce que toutes les valeurs de signaux du treillis déterminé aient été prises en compte :

    a) on choisit une zone partielle du treillis, la zone partielle présentant une valeur partielle de signal de départ et une valeur partielle de signal de fin sur le chemin de vraisemblance maximale,
    b) on détermine dans la zone partielle du treillis un autre chemin qui se termine par la valeur partielle de signal de fin du chemin de vraisemblance maximale,
    c) on compare chaque valeur de signal sur l'autre chemin à avec chaque valeur de signal sur le chemin de vraisemblance maximale,
    d) on forme pour chaque valeur de signal sur le chemin de vraisemblance maximale, le minimum entre la valeur de fiabilité affectée à la valeur de signal et la valeur de fiabilité de la valeur partielle de signal de fin,
    e) on choisit selon un critère prédéterminé la valeur de fiabilité ou le minimum et on l'affecte à la valeur de signal respective, et

- on utilise sous la forme d'une suite décodée les valeurs de signaux déterminées et les valeurs de fiabilité choisies affectées aux valeurs de signaux.

17. Dispositif selon la revendication 16, comprenant :

- une unité de détermination de métriques de transition pour déterminer une métrique de transition,
- une unité de détermination de métriques d'état final couplée à l'unité de détermination de métriques de transition pour déterminer une métrique d'état final,

- une unité de détermination de valeurs de fiabilité couplée à l'unité de détermination de métriques d'état final,
- une unité de traçabilité de chemin couplée à l'unité de détermination de valeurs de fiabilité et à l'unité de détermination de métriques d'état final pour déterminer des informations de traçabilité de chemins.

**18.** Dispositif selon la revendication 16 ou 17, comprenant une mémoire comportant :

- une première zone de mémoire pour mémoriser des informations de traçabilité de chemins, et/ou
- une deuxième zone de mémoire pour mémoriser des informations d'entrée pondérées pour l'unité de décodage, et/ou
- une troisième zone de mémoire pour mémoriser des métriques d'état et des métriques de transition d'état déterminées, et/ou
- une quatrième zone de mémoire pour mémoriser des valeurs de signaux prévues pour l'affichage et les valeurs de fiabilité affectées aux valeurs de signaux.

**19.** Dispositif selon la revendication 18, dans lequel au moins une des zones de mémoire se présente sous la forme d'une RAM.

**20.** Dispositif selon l'une quelconque des revendications 17 à 19, dans lequel l'unité de traçabilité de chemins présente les composants suivants :

- une unité de commande 702,
- un multiplexeur qui est couplé à l'unité de commande via une entrée de commande,

  - où l'on peut décider via l'entrée de commande si le premier multiplexeur choisit des informations sur le chemin de vraisemblance maximale ou sur l'autre chemin concurrent,
  - où l'on peut acheminer à une première entrée du premier multiplexeur l'état de départ respectif pour le procédé de traçabilité de chemins à l'intérieur de l'autre chemin concurrent,
  - où l'on peut acheminer à une deuxième entrée du premier multiplexeur des informations pour savoir si un bit de transition doit être inversé dans la traçabilité de l'autre chemin,
  - où l'on peut acheminer à une troisième entrée du premier multiplexeur le moment respectif qui se réfère à l'état de départ,
  - où l'on peut acheminer à une quatrième entrée du premier multiplexeur l'état de départ respectif du chemin de vraisemblance maximale, et
  - où l'on peut acheminer à une cinquième entrée du premier multiplexeur le moment respectif qui se rapporte à l'état de départ du chemin de vraisemblance maximale.

FIG 1

52 MHz

101 — Maximum-Likelihood-Pfad 103

Primäre TB-Ergebnisse

102 Pfadrückverfolgungs-Ergebnisse 2x45 bits

...Sekundäre TB-Ergebnisse

zweiter Pfad — 104

volle Pfadmetriken (Zeit=k, Zustand=m)

Für Knoten über Max.-Likel.-Pfad und zweiten Pfad Ms(k,m) und Mc(k,m)

von METRIK-Datenpfad

Ermögliche Pfadmetriken für Knoten (k,m) 707

Pfadrückverfolgungs-Einheit SOVA

Zustand am Anfang | Andere Anfangs-Übergangs-bit | Zeit am Anfang | Start/Stop Sec.TB

702 — FSM_SOVA

Pr.TB(k-i)    Sec.TB(k-i)

SOVA_Datenpfad

=? — 105

Berechnung des Referenzzustands (Zeit=k, Zustand=m, Max.-Likel.-Pfad) — 106

Sub 117 | 111 | 110 Min 112 114 | 109 107 Mux 116 | 115 108

Aktualisiere S(k-i) mit Referenz auf S(k) i=1,..., Größe des Verschiebefensters

S(k-i) | S(k-i)_ | S(k)    Aktualisierung

sekundäres Pfadrückverfolgungs-Fenster

~706

113 · ...

721

8x16 Bit    1x16 Bit Referenz    RAM_ERGEBNIS

Zuverlässigkeitsentscheidungs-Ausgabe (zeitliche Register zum Aktualisieren von Zuverlässigkeitswerten innerhalb des sekundären Pfadrückverfolgungs-Fensters)

722

EP 1 334 563 B1

FIG 2

EP 1 334 563 B1

## FIG 3

eingeschobenes Bit,

Übergangsbit $= a'_{k-7}$ or $a_{k-7}$

$M(k,m'=2i)$

$m'=(a_k,a_{k-1},a_{k-2},a_{k-3},a_{k-4},a_{k-5},a_{k-6},a'_{k-7})$ l1

eingeschobenes Bit $a_{k+1}=0$    303

$M(k+1,m''=i)$

$m''=(a_{k+1},a_k,a_{k-1},a_{k-2},a_{k-3},a_{k-4},a_{k-5},a_{k-6})$

301

l2

307

305

304  l3  k+1   300

302

l4   306

eingeschobenes Bit $a_{k+1}=1$

308

$M(k,m=2i+1)$

$m=(a_k,a_{k-1},a_{k-2},a_{k-3},a_{k-4},a_{k-5},a_{k-6},a_{k-7})$

$M(k+1,m'''=i+N/2)$

neue Zustandsmetriken

$$M(k+1,m''=i)=\max(M(k,m'=2i)+l1, M(k,m=2i+1)+l2)$$
$$M(k+1,m'''=i+N/2)=\max(M(k,m'=2i)+l3, M(k,m=2i+1)+l4)$$

Übergangsbits

$$(M(k,m'=2i)+l1 >= M(k,m=2i+1)+l2) ? a'_{k-7}:a_{k-7}$$
$$(M(k,m'=2i)+l3 >= M(k,m=2i+1)+l4 ? a'_{k-7}:a_{k-7}$$

FIG 4

Pfadrückverfolgungs-Zustände zum Zeitpunkt k, 256 Zustände — 401

Start-Zustand für Pfadrückverfolgung zum Zeitpunkt k

Pfadrückverfolgungs-Zustände zum Zeitpunkt k-1, 256 Zustände

Zustand zum Zeitpunkt k für Pfadrückverfolgung — 405

| $a_k$ | $a_{k-1}$ | $a_{k-2}$ | $a_{k-3}$ | $a_{k-4}$ | $a_{k-5}$ | $a_{k-6}$ | $a_{k-7}$ |

402

Zeiger auf eine Pfad-rückverfolgungs-Adresse für Zeitschritt k, Zustand des Maximum-Likelihood-Pfads k

403 — Pfadrückverfolgungs-Adresse

| | | | ... | | | |
404

dekodierter Signalwert zum Zeitpunkt k

Pfadrückverfolgungs-Zustände zum Zeitpunkt k-1, 256 Zustände — 406

Zustand zum Zeitpunkt k-1 für Pfadrückverfolgung

| $a_{k-1}$ | $a_{k-2}$ | $a_{k-3}$ | $a_{k-4}$ | $a_{k-5}$ | $a_{k-6}$ | $a_{k-7}$ | Pfad-rück-verfol-gungs-Zustand |

410

407

Zeiger auf eine Pfad-rückverfolgungs-Adresse für Zeitschritt k-1, Zustand des Maximum-Likelihood-Pfads k-1

| | | | ... | | | |
408

409

dekodierter Signalwert zum Zeitpunkt k-1

# FIG 5

Pr.TB(k-i)=dekodierter **Signalwert des** Maximum-Likelihood-Pfads,
Sec.TB(k-i)=dekodierter **Signalwert des zweiten** Pfads
S(k-i)=Zuverlässig-keitswert   ; Ms(k,m) = Gesamtmetrik entlang Maximum-Likelihood-Pfad,
   Mc(k,m) = Gesamtmetrik entlang zweitem Pfad

k=Zeitschritt
m=Zustand
i=0, ..., Fenstergröße

k-i    k-3    k-2    k-1    k

Fenstergröße=5x Constrain-Länge — 503

Primär TB=TB   für Zwangsentscheidungs-Viterbi

Sekundär TB=TB über zweiten Pfad innerhalb der Größe des Verschiebefensters — 502

PR.TB(k-3)   PR.TB(k-2)

Maximum-Likelihood-Pfad   PR.TB(k-1)   — 502   — 502   — 500

507   Sec.TB(k-3)   — 507   PR.TB(k)   — 502
zweiter Pfad   506   505   Ms(k,m)   504   — 502
507   507   Knoten (k,m)   501
Sec.TB(k-2)   Sec.TB(k-1)   Mc(k,m)   — 502   Knoten (k+1,m')
   Sec.TB(k)

Der Viterbi-Algorithmus muß zweifach angewendet werden. Zum Aktualisieren der Zuverlässigkeitswerte muß die Kenntnis der primären Pfadrückverfolgungs-Register (Traceback-Register) zusammen mit der Trellis und den empfangenen Signalwerten verwendet werden.

Wenn (Sec.TB(k-i)=Pr.TB(k-i))
Dann S(k-i)=S(k-i) sonst
S(k-i)=min [S(k-i),S(k)]
Ende Wenn;

Wenn (Sec. TB(k-3)=Pr.TB(k-3))
Dann S(k-3)=S(k-3) sonst
S(k-3)=min[S(k-3),S(k)]
Ende Wenn;

Wenn (Sec. TB(k-2)=Pr.TB(k-2))
Dann S(k-2)=S(k-2) sonst
S(k-2)=min[S(k-2),S(k)]
Ende Wenn;

508

Wenn (Sec. TB(k-1)=Pr.TB(k-1))
Dann S(k-1)=S(k-1) sonst
S(k-1)=min[S(k-1),S(k)]
Ende Wenn;

S(k)=Ms(k,m)-Mc(k,m)

Verschieben des Fensters um einen Zeitschritt und wiederholen der ganzen Rechnung

EP 1 334 563 B1

Notwendige Information: der Viterbi-Algorithmus muß zweifach angewendet
werden

0. Maximum-Likelihood-Pfad von primärer Pfadrückverfolgung.
1. zur Festsetzung der sekundären Pfadrückverfolgung: gesamte
   Pfadrückverfolgungsinformation von primärer Viterbi-Rechnung
2. zur Festsetzung von Ms(...) und Mc(...); empfangene Signalwerte
3. Trellis-Information

k=0    k=1    k=2    k=3    k=4

verschiebe Fenster um 1 Zeitschritt
und wiederhole die ganze Rechnung

**FIG 6**

614 — Sec.TB(1) upd_3
Sec.TB(2) upd_3 — 616
zweiter Pfad 3    615
Mc(3,m3)    613
Sec.TB(3) upd_3    612
609 — 608   610   Mc(2,m2)   Pr.TB(3)   Ms(4,m4)   /500
zweiter Pfad 2    607    617   Ms(3,m3)
Pr.TB(2)   618
622 — 623   624   620
Pr.TB(1)   625
602   621   Mc(4,m4)
zweiter Pfad 4
Ms(1,m1)   Mc(2,m2)
zweiter Pfad 1   604 — 605   603
Mc(1,m1)   601   606   611   619   501

Sec.TB(n) upd k:
dekodierter Signalwert
zur Zeit n des zweiten
Pfads während
Aktualisierungssequenz k

Pr.TB(k):
dekodierter Signalwert
zur Zeit k des Maximum-
Likelihood-Pfads

$S(1)=Ms(1,m1)-Mc(1,m1)$

Wenn $(Sec.TB(1) \; upd\_2=Pr.TB(1))$
Dann $S(1)=S(1)$ sonst
$S(1)=min[S(1),S(2)]$
Ende wenn:
aktualisiere $S(1)$
aktualisiere $S(1)$

$S(2)=Ms(2,m2)-Mc(2,m2)$

aktualisiere $S(2)$   $S(3)=Ms(3,m3)-Mc(3,m3)$
aktualisiere $S(2)$ aktualisiere $S(3)$   $S(4)=Ms(4,m4)-Mc(4,m4)$

1. Aktualisierungssequenz
2. Aktualisierungssequenz
3. Aktualisierungssequenz
4. Aktualisierungssequenz

aktualisiere S(i) mit S(k)
als Referenz: Wenn
$(Sec.TB(i) \; upd \; k=Pr.TB(i)$ Dann
$S(i)=S(i)$ sonst
$S(i)=min[S(i),S(k)]$ Ende Wenn:

# FIG 7

EP 1 334 563 B1

FIG 8

34